# EUROPEAN PATENT APPLICATION

(11) **EP 4 517 814 A1**
(43) Date of publication of application: **05.03.2025**
(21) Application number: 22941774.6
(22) Date of filing: 12.05.2022
(51) Int. Cl.: H01L 23/473, H01L 23/367, H01L 23/373

(54) **DOUBLE-SIDE-COOLING POWER SEMICONDUCTOR PACKAGE**

(71) Applicant: LG Magna e-Powertrain Co., Ltd., Seo-gu, Incheon 22744 (KR)
(72) Inventor: KANG, Myeongyu, Incheon 22744 (KR); KIM, Yongsik, Incheon 22744 (KR); PARK, Younghun, Incheon 22744 (KR); CHOI, Honggoo, Incheon 22744 (KR)
(74) Representative: Vossius & Partner Patentanwälte Rechtsanwälte mbB
(86) International application number: PCT/KR2022/006826
(87) International publication number: WO 2023/219187

(57) **Abstract**

The present invention relates to a double-side-cooling power semiconductor package and comprises: a planar power semiconductor package; a plurality of coolers which have therein a flow path for a cooling fluid, and are respectively disposed on both planar sides of the power semiconductor package so as to allow heat exchange; and a connecting member which has therein the flow path for the cooling fluid, and is connected to the plurality of coolers so as to be in communication therewith, wherein the connecting member is configured to be extensible. Accordingly, the occurrence of deformation and damage in the event of thermal expansion of the power semiconductor package can be inhibited.

## Description

### Technical Field

The present disclosure relates to a double-side cooling power semiconductor package.

### Background Art

As is generally known, semiconductor elements are electronic circuit elements made of semiconductors.

Among those semiconductor elements, an electric power module, a power module or a power semiconductor package (hereinafter, referred to as a "power semiconductor package") implemented as a package including an IGBT and a diode is used for power control of a power device.

The power semiconductor package is typically used in industrial applications such as inverters, uninterruptible power supplies, welders, elevators, and automotive fields.

However, in such a conventional power semiconductor package, a large amount of heat loss occurs during a power conversion process, and the occurrence of heat loss not only causes a temperature rise in the power semiconductor package, but also, if the temperature of the power semiconductor package increases and exceeds an operating temperature limit of the power semiconductor package, there is a problem in that the function of the power semiconductor package may be damaged.

In consideration of those problems, there is disclosed a cooling device of a power semiconductor package capable of cooling the power semiconductor package by allowing a cooling channel to be disposed in contact with both sides of the power semiconductor package.

However, in such a conventional cooling device of the power semiconductor package, the cooling channel is disposed to have a long length so as to sequentially pass through upper and lower surfaces of the power semiconductor package, so there is a problem in that a flow resistance of the cooling fluid (coolant) increases.

Furthermore, a temperature deviation between the cooling fluid in the cooling channel on an upper surface of the power semiconductor package and the cooling fluid in the cooling channel on a lower surface of the power semiconductor package increases, so there is a problem in that forced deterioration is accelerated because cooling in regions with relatively high temperatures is insufficient.

In addition, there is a problem that power semiconductor packages that come into contact with a downstream region of the cooling channel, in which the temperature of the cooling fluid is relatively high, are relatively poorly cooled compared to those that come into contact with an upstream region of the cooling channel, in which the temperature of the cooling fluid is relatively low.

Moreover, since a surface of the cooling channel is structured to be in direct contact with the surface of the power semiconductor package, there is a problem in that heat exchange between the power semiconductor package and the cooling fluid inside the cooling channel is insufficient.

In consideration of those problems, some have designed a double-side cooling device of a power semiconductor package having a direct cooling passage that allows cooling fluid to be in direct contact with upper and lower surfaces of the power semiconductor package.

However, in such a conventional double-side cooling device of a power semiconductor package having a direct cooling passage, upper and lower surfaces of the power semiconductor package are in direct contact with cooling fluid, so there is a problem in that an increase in heat dissipation area of the power semiconductor package is limited, resulting in insufficient heat exchange.

Meanwhile, in such a conventional cooling device of a power semiconductor package, when the power semiconductor package is operated and stopped, the power semiconductor package repeatedly undergoes thermal expansion and contraction, and thus stress is concentrated in a joint region of the power semiconductor package and/or the cooling channel, and as a result, resulting in a problem of causing damage to the power semiconductor package and the cooling channel.

### [Citation List]

### [Patent Literature]

(Patent Literature 1) KR1020170056196 (published on May 23, 2017)
(Patent Literature 2) KR1020170042067 (published on April 18, 2017)

### Disclosure of Invention

### Technical Problem

Accordingly, an aspect of the present disclosure is to provide a double-side cooling power semiconductor package capable of suppressing deformation and damage caused by thermal expansion of the power semiconductor package.

Furthermore, another aspect of the present disclosure is to provide a double-side cooling power semiconductor package capable of shortening a passage of cooling fluid.

In addition, still another aspect of the present disclosure is to provide a double-side cooling power semiconductor package capable of suppressing the occurrence of a temperature deviation between upper and lower surfaces of the power semiconductor package.

### Solution to Problem

In order to solve the foregoing problems, in a double-side cooling power semiconductor package according to the present disclosure, an extensible connecting member may be connected to coolers disposed on both sides of the power semiconductor package.

Specifically, a plurality of coolers may be respectively disposed on both plate surfaces along a thickness direction of the power semiconductor package, and extensible connecting members may be respectively connected to one sides of the plurality of coolers so as to allow the connecting members to absorb, when the power semiconductor package is thermally deformed (contracted and expanded), the deformation (contraction and expansion), thereby suppressing damage to the power semiconductor package and peripheral components from occurring.

A double-side cooling power semiconductor package in one embodiment of the present disclosure may include a plate-shaped power semiconductor package; a plurality of coolers provided with passages of cooling fluid thereinside, respectively, and disposed on both plate surfaces of the power semiconductor package, respectively, so as to allow heat exchange; and a connecting member provided with the passage of cooling fluid thereinside, and connected in communication with the plurality of coolers, wherein the connecting member is disposed to be extensible.

Accordingly, when thermal deformation (expansion and contraction) of the power semiconductor package occurs, the deformation (expansion and contraction) may be absorbed by the connecting member while contracting and extending, thereby suppressing the deformation of the power semiconductor package and/or the deformation of the cooler from occurring.

In one embodiment of the present disclosure, the connecting member may be provided with a corrugated pipe shape.

Specifically, the connecting member is configured with coupling portions provided in a tubular shape at both end portions thereof, and a corrugated portion that is extensible with an outer diameter extended compared to the coupling portions.

Through this, the extension and contraction of the connecting member may be efficiently achieved.

In one embodiment of the present disclosure, the connecting member may be disposed to be extensible along a thickness direction of the power semiconductor package.

One end portion of the connecting member may be connected to one of the plurality of coolers, and the other end portion thereof may be connected to another one of the plurality of coolers, thereby allowing, when the power semiconductor package expands along a thickness direction, the connecting member to absorb deformation while being extended along the thickness direction.

Furthermore, when the power semiconductor package is contracted along the thickness direction, the connecting member may be contracted along the thickness direction to absorb the deformation.

In one embodiment of the present disclosure, the connecting member may be disposed to be extensible along a plate surface direction of the power semiconductor package.

Accordingly, when the power semiconductor package expands along a plate surface direction, the connecting member may be contracted along the plate surface direction to absorb the deformation.

In addition, when the power semiconductor package is contracted along the plate surface direction, the connecting member may be extended along the plate surface direction to absorb the deformation.

In one embodiment of the present disclosure, the plurality of coolers may respectively include an inner plate that comes into contact with the power semiconductor package; an outer plate disposed to be spaced apart from the inner plate; and a partition, one side of which is connected to the inner plate and the other side of which is connected to the outer plate.

Through this, a contact area between the plurality of coolers and cooling fluid may be increased to increase an amount of heat exchange.

Through this, heat dissipation (cooling) of the power semiconductor package may be accelerated.

In addition, a plurality of coolers may be manufactured by using extrusion to easily perform the manufacture of the plurality of cooler.

In one embodiment of the present disclosure, the plurality of coolers may respectively include an inner plate that comes into contact with the power semiconductor package; an outer plate disposed to be spaced apart from the inner plate; and a heat dissipation fin, one side of which is connected to the inner plate and the other side of which is connected to the outer plate.

Through this, a heat exchange area between the plurality of coolers and the cooling fluid may be increased.

Additionally, an amount of heat exchange between the cooling fluid and the plurality of coolers may be controlled by controlling a size, a number, and a spacing of the heat dissipation fin(s).

Through this, cooling of the power semiconductor package may be accelerated.

In one embodiment of the present disclosure, the plurality of coolers may respectively include an upper cooler provided on an upper side of the power semiconductor package; and a lower cooler provided on a lower side of the power semiconductor package, wherein the connecting member is provided at the inlet-side and outlet-side end portions of the lower cooler and the upper cooler, respectively, with respect to a flow direction of the cooling fluid.

Through this, when the power semiconductor package undergoes thermal expansion, deformation may be absorbed by the connecting members provided at inlet-side end portions of the lower cooler and the upper cooler and the connecting members provided at outlet-side end portions of the lower cooler and the upper cooler, respectively.

Through this, the occurrence of damage to the power semiconductor package, the upper cooler and the lower cooler caused by thermal expansion of the power semiconductor package may be suppressed.

In one embodiment of the present disclosure, the cooler may further include headers provided at the inlet-side and outlet-side end portions of the lower cooler and upper cooler, respectively.

The connecting member may be vertically disposed between a header of the upper cooler and a header of the lower cooler to be connected in communication with the headers.

Through this, when the power semiconductor package undergoes thermal expansion, the connecting members absorb the deformation, thereby suppressing damage to the power semiconductor package, the lower cooler, and the upper cooler from occurring.

In one embodiment of the present disclosure, the header may be provided with a connecting member coupling portion to which the connecting member is coupled to overlap along a thickness direction of the power semiconductor package.

Through this, a length of the connecting member may be secured sufficiently so as to easily achieve deformation (extension and contraction).

In one embodiment of the present disclosure, the connecting member coupling portion may include a recessed portion that is recessed in a thickness direction so as to receive an end portion of the connecting member.

Through this, excessive compression of the connecting member during the contraction of the connecting member may be suppressed.

In one embodiment of the present disclosure, the recessed portion may be provided with an inner width greater than a maximum outer width of the connecting member (an outer width of the corrugated portion).

Through this, during the contraction of the connecting member, an outermost region (the corrugated portion) is received into the recessed portion along a width direction of the connecting member without interfering with the recessed portion.

In one embodiment of the present disclosure, the connecting member coupling portion may be provided with an overlapping section that protrudes from the recessed portion to overlap with an end portion of the connecting member (the coupling portion) in a length direction.

Through this, during the contraction of the connecting member, the corrugated portion of the connecting member may be prevented from coming into contact with a bottom portion of the recessed portion along a length direction of the connecting member.

In one embodiment of the present disclosure, the overlapping section may be configured to have a length smaller than a depth of the recessed portion.

Through this, during the contraction of the connecting member, the corrugated portion of the connecting member may be inserted into the recessed portion.

In one embodiment of the present disclosure, the inner plate, outer plate and heat dissipation fin may be formed of a metal member, wherein the inner plate, outer plate, and heat dissipation fin are coupled to one another by brazing.

Through this, the occurrence of leakage of the cooler may be suppressed.

In one embodiment of the present disclosure, the power semiconductor package may include a first power semiconductor package, a second power semiconductor package, and a third power semiconductor package spaced apart from one another along a plate surface direction.

The upper cooler may include a first upper cooler, a second upper cooler and a third upper cooler, which are respectively disposed on upper sides of the first power semiconductor package, the second power semiconductor package and the third power semiconductor package.

The lower cooler may include a first lower cooler, a second lower cooler, and a third lower cooler, which are respectively disposed on lower sides of the first power semiconductor package, the second power semiconductor package, and the third power semiconductor package.

Here, the first upper cooler, the second upper cooler, and the third upper cooler are connected in series, and the first lower cooler, the second lower cooler, and the third lower cooler are connected in series.

The first upper cooler and the first lower cooler are connected in communication with each other by the connecting member, and the third upper cooler and the third lower cooler are connected in communication with each other by the connecting member.

Through this, upper and lower surfaces of the first power semiconductor package, the second power semiconductor package, and the third power semiconductor package are respectively uniformly cooled so as to suppress a temperature deviation between the upper and lower surfaces from occurring.

In one embodiment of the present disclosure, the connecting member may include an upper horizontal connecting member that connects the first upper cooler, the second upper cooler, and the third upper cooler along a horizontal direction, and a lower horizontal connecting member that connects the first lower cooler, the second lower cooler, and the third lower cooler along a horizontal direction.

Specifically, the first upper cooler and the second upper cooler are connected in communication with each other through the upper horizontal connecting member, and the second upper cooler and the third upper cooler are connected in communication with each other through the upper horizontal connecting member.

In addition, the first lower cooler and the second lower cooler are connected in communication with each other through the lower horizontal connecting member, and the second lower cooler and the third lower cooler are connected in communication with each other through the lower horizontal connecting member.

Through this, when the first power semiconductor package, the second power semiconductor package, and the third power semiconductor package undergo thermal deformation (contraction and expansion), the upper horizontal connecting member and the lower horizontal connecting member absorb the deformation while extending and contracting, thereby suppressing damage caused by thermal deformation (stress) of the first power semiconductor package, the second power semiconductor package, the third power semiconductor package, the first upper cooler, the second upper cooler, the third upper cooler, the first lower cooler, the second lower cooler, and the third lower cooler.

In one embodiment of the present disclosure, the power semiconductor package may include a first power semiconductor package, a second power semiconductor package, and a third power semiconductor package disposed to be spaced apart from one another along a thickness direction

The cooler may include a first cooler disposed on a lower side of the first power semiconductor package, a second cooler disposed on an upper side of the first power semiconductor package, a third cooler disposed on an upper side of the second power semiconductor package, and a fourth cooler disposed on an upper side of the third power semiconductor package.

The respective inlet-side end portions of the first cooler, second cooler, third cooler and fourth cooler may be connected in communication with one another by the connecting member.

The respective outlet-side end portions of the first cooler, second cooler, third cooler and fourth cooler may be connected in communication with one another by the connecting member.

Through this, temperature deviations between the upper and lower surfaces of the first power semiconductor package, the second power semiconductor package, and the third power semiconductor package may be respectively suppressed from occurring.

In addition, when the first power semiconductor package, the second power semiconductor package, and the third power semiconductor package undergo thermal deformation, damage to the first power semiconductor package, the second power semiconductor package, the third power semiconductor package, the first cooler, the second cooler, the third cooler, and the fourth cooler may be suppressed from occurring.

In one embodiment of the present disclosure, a first header, a second header, a third header and a fourth header may be respectively provided at inlet-side and outlet-side end portions of the first cooler, the second cooler, the third cooler and the fourth cooler with respect to a movement direction of the cooling fluid.

The connecting member may include a first vertical connecting member, a second vertical connecting member, and a third vertical connecting member disposed in a vertical direction between the first header, the second header, the third header, and the fourth header spaced apart vertically from one another.

Through this, when the first power semiconductor package, the second power semiconductor package, and the third power semiconductor package undergoes thermal deformation, the first vertical connecting member, the second vertical connecting member, and the third vertical connecting member may absorb the deformation of the first power semiconductor package, the second power semiconductor package, and the third power semiconductor package, respectively, while extending or contracting.

In one embodiment of the present disclosure, a thermally conductive material inserted between contact surfaces of the power semiconductor package and the cooler may be provided.

Through this, an amount of air between contact surfaces of the power semiconductor package and the cooler may be reduced so as to easily perform heat transfer from the power semiconductor package to the cooler.

Through this, heat dissipation (cooling) of the power semiconductor package may be accelerated.

In one embodiment of the present disclosure, contact surfaces of the power semiconductor package and the cooler are boned each other by soldering.

Through this, an amount of air between the contact surfaces of the power semiconductor package and the cooler may be reduced.

Through this, heat dissipation (cooling) of the power semiconductor package may be accelerated.

### Advantageous Effects of Invention

As described above, according to one embodiment of the present disclosure, a power semiconductor package may be provided with a plurality of coolers on both sides thereof, and provided with a connecting member connected in communication with the plurality of coolers, the connecting member being configured to extend and contract so as to absorb, when the power semiconductor package is thermally deformed, the deformation by the connecting member absorbs, thereby suppressing damage to the power semiconductor package and the coolers.

Furthermore, the connecting member may be provided in a corrugated pipe shape, thereby easily performing deformation absorption.

In addition, the connecting member may be disposed in an extensible manner along a thickness direction of the power semiconductor package so as to allow, when the power semiconductor package is thermally deformed in the thickness direction, the connecting member to absorb the deformation while extending and contracting, thereby suppressing damage to the power semiconductor package and the coolers from occurring.

Moreover, the connecting member may be disposed in an extensible manner along a plate surface direction of the power semiconductor package so as to allow, when the power semiconductor package expands along a plate surface direction, the connecting member to absorb deformation while contracting, thereby suppressing damage to the power semiconductor package and the coolers from occurring.

Besides, the plurality of coolers may be configured with an inner plate, an outer plate, and a plurality of partitions so as to increase a contact area with respect to cooling fluid, thereby accelerating heat dissipation.

Furthermore, a plurality of coolers may be provided with an inner plate, an outer plate, and a heat dissipation fin, thereby increasing a heat exchange area with respect to cooling fluid.

In addition, the plurality of coolers may be provided with an upper cooler and a lower cooler, and connecting members may be provided at inlet-side and outlet-side end portions of the upper cooler and the lower cooler, respectively, thereby absorbing, when thermal deformation of the power semiconductor package occurs, the deformation by the connecting members provided at the inlet-side and outlet-side end portions, respectively.

Moreover, headers may be provided at inlet-side and outlet-side end portions of the plurality of coolers, respectively, and the respective headers may be provided with vertical connection member coupling portions to which vertical connecting members are coupled to overlap along a thickness direction of the power semiconductor package so as to secure a sufficient length during the extension of the vertical connection members, thereby easily performing extension and contraction.

Furthermore, the vertical connecting member coupling portion may be provided with a recessed portion that is recessed in the thickness direction, thereby suppressing the vertical connecting member from being excessively compressed during the contraction of the vertical connecting member.

In addition, the recessed portion may be provided with an inner width greater than a maximum outer width of the vertical connecting member, thereby suppressing the vertical connecting member from interfering with the recessed portion while extending and contracting.

Moreover, since the inner plate, outer plate, and heat dissipation fin may be joined to one another by brazing, thereby suppressing the leakage of the cooler from occurring.

Besides, the power semiconductor package may be provided with a first power semiconductor package, a second power semiconductor package and a third power semiconductor package spaced apart from one another along a plate surface direction, the upper cooler may be provided with a first upper cooler, a second upper cooler and a third upper cooler, and the lower cooler may be provided with a first lower cooler, a second lower cooler and a third lower cooler, thereby suppressing a temperature deviation between upper and lower surfaces of the first power semiconductor package, the second power semiconductor package and the third power semiconductor package.

Furthermore, the first upper cooler, the second upper cooler, and the third upper cooler may be connected in communication with one another through an upper horizontal connecting member, and the first lower cooler, the second lower cooler, and the third lower cooler may be connected in communication with one another through a lower horizontal connecting member, thereby absorbing, when the first power semiconductor package, the second power semiconductor package, and the third power semiconductor package undergo thermal deformation, the deformation by the upper horizontal connecting member and the lower horizontal connecting member.

In addition, the power semiconductor package may include a first power semiconductor package, a second power semiconductor package, and a third power semiconductor package spaced apart from one another in a thickness direction, and the cooler may include a first cooler provided on a lower side of the first power semiconductor package, a second cooler provided on an upper side of the second power semiconductor package, a third cooler provided on an upper side of the second power semiconductor package, and a fourth cooler provided on an upper side of the third power semiconductor package, thereby suppressing a temperature deviation between upper and lower surfaces of the first power semiconductor package, the second power semiconductor package, and the third power semiconductor package.

Moreover, a first header, a second header, a third header and a fourth header may be provided on inlet and outlet sides of the first cooler, the second cooler, the third cooler and the fourth cooler, respectively, and a first vertical connecting member, a second vertical connecting member and a third vertical connecting member may be provided between the first header, the second header, the third header and the fourth header, thereby allowing, when the first power semiconductor package, the second power semiconductor package and the third power semiconductor package are thermally deformed, the first vertical connecting member, the second vertical connecting member and the third vertical connecting member to absorb the deformation of the first power semiconductor package, the second power semiconductor package and the third power semiconductor package, respectively, while extending or contracting.

Besides, a thermally conductive material may be inserted between contact surfaces of the power semiconductor package and the cooler so as to reduce an amount of air between the contact surfaces of the power semiconductor package and the cooler, thereby easily performing heat transfer from the power semiconductor package to the cooler.

### Brief Description of Drawings

FIG. 1 is a perspective view of a double-side cooling power semiconductor package according to one embodiment of the present disclosure.
FIG. 2 is a cross-sectional view prior to the contraction of a connecting member of the double-side cooling power semiconductor package of FIG. 1.
FIG. 3 is a cross-sectional view of the double-side cooling power semiconductor package of FIG. 1.
FIG. 4 is a view for explaining an operation of the double-side cooling power semiconductor package of FIG. 3.
FIG. 5 is a cross-sectional view of a modified example of the double-side cooling power semiconductor package of FIG. 1.
FIG. 6 is a cross-sectional view of a cooler in FIG. 5.
FIG. 7 is a cross-sectional view of a compressed state of a connecting member in FIG. 5.
FIG. 8 is a view for explaining an operation of the double-side cooling power semiconductor package of FIG. 7.
FIG. 9 is a perspective view of a double-side cooling power semiconductor package according to another embodiment of the present disclosure.
FIG. 10 is a perspective view of an upper cooler and a lower cooler in FIG. 9.
FIG. 11 is an exploded perspective view of the upper cooler and the lower cooler of FIG. 10.
FIG. 12 is a cross-sectional view prior to the contraction of a vertical connecting member of the double-side cooling power semiconductor package of FIG. 9.
FIG. 13 is a front view of a body of the cooler (lower cooler) in FIG. 11.
FIG. 14 is a perspective view of a horizontal connecting member (upper horizontal connecting member) in FIG. 11.
FIG. 15 is an enlarged view of a region of the horizontal connecting member (upper horizontal connecting member) in FIG. 12.
FIG. 16 is a perspective view of a vertical connecting member in FIG. 11.
FIG. 17 is an enlarged view of a region of the vertical connecting member of FIG. 12.
FIG. 18 is a perspective view of an outlet-side header in FIG. 11.
FIG. 19 is a cross-sectional view subsequent to the contraction of the vertical connecting member of the double-side cooling power semiconductor package of FIG. 12.
FIG. 20 is a view for explaining an operation of the double-side cooling power semiconductor package of FIG. 17.
FIG. 21 is a perspective view of a double-side cooling power semiconductor package according to still another embodiment of the present disclosure.
FIG. 22 is a cross-sectional view prior to the contraction of a connecting member of the double-side cooling power semiconductor package of FIG. 21.
FIG. 23 is a cross-sectional view subsequent to the contraction of the connecting member of the double-side cooling power semiconductor package of FIG. 21.
FIG. 24 is a view for explaining an operation of the double-side cooling power semiconductor package of FIG. 22.

### Mode for the Invention

Hereinafter, embodiments disclosed herein will be described in detail with reference to the accompanying drawings. Herein, even in different embodiments, the same or similar reference numerals are designated to the same or similar configurations, and the description thereof will be substituted by the earlier description. A singular expression used herein may include a plural expression unless clearly defined otherwise in the context. In describing embodiments disclosed herein, moreover, the detailed description will be omitted when specific description for publicly known technologies to which the invention pertains is judged to obscure the gist of the present disclosure. Also, it should be noted that the accompanying drawings are merely illustrated to easily explain the concept of the invention, and therefore, they should not be construed to limit the technological concept disclosed herein by the accompanying drawings.

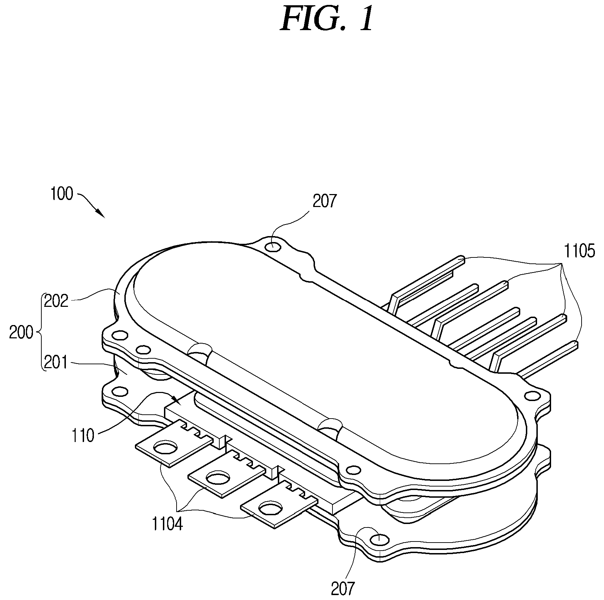

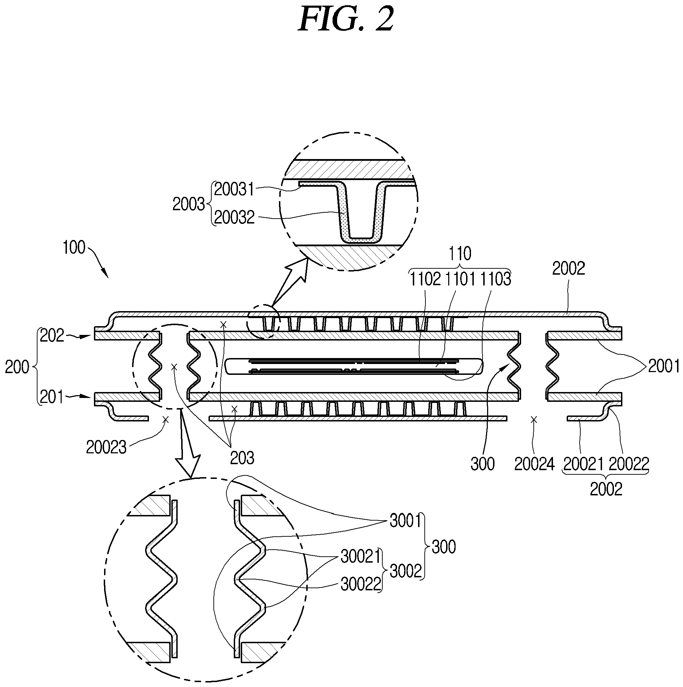

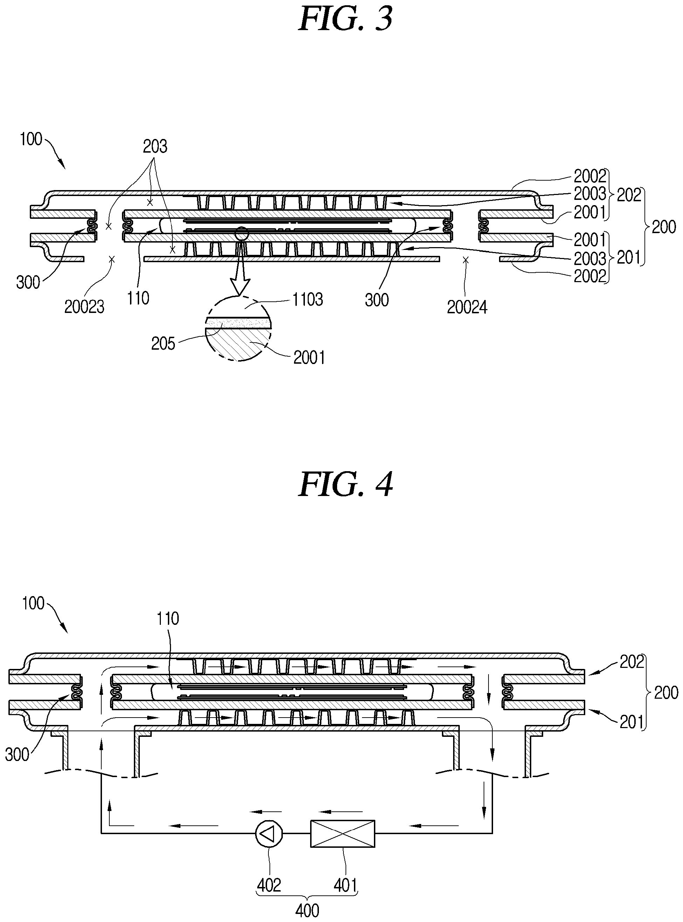

FIG. 1 is a perspective view of a double-side cooling power semiconductor package according to one embodiment of the present disclosure, FIG. 2 is a cross-sectional view prior to the contraction of a connecting member of the double-side cooling power semiconductor package of FIG. 1, FIG. 3 is a cross-sectional view of the double-side cooling power semiconductor package of FIG. 1, and FIG. 4 is a view for explaining an operation of the double-side cooling power semiconductor package of FIG. 3.

As shown in FIGS. 1 to 3, a double-side cooling power semiconductor package 100 according to one embodiment of the present disclosure includes a power semiconductor package 110, a cooler 200, and a connecting member 300.

The power semiconductor package 110 has a rectangular plate shape with an approximately thin thickness.

The power semiconductor package 110 is configured with, for example, a plurality of circuit elements 1101, an upper substrate 1102 disposed on an upper side along a thickness direction of the plurality of circuit elements 1101, and a lower substrate 1103 provided on a lower side of the plurality of circuit elements 1101. Although not specifically shown in the drawing, the plurality of circuit elements 1101 are configured with, for example, an insulated gate bipolar transistor (IGBT) and a diode.

A power lead 1104 is provided on one side of the power semiconductor package 110, and a plurality of signal leads 1105 are provided on the other side of the power lead 1104. In this embodiment, the power lead 1104 is disposed in a thin plate shape. The signal lead 1105 is implemented in a rectangular bar shape.

The cooler 200 is provided with a passage 203 through which cooling fluid moves thereinside.

The double-side cooling power semiconductor package 100 in this embodiment is provided, for example, in a vehicle or an electric vehicle, and the cooling fluid may be implemented as coolant of the vehicle or electric vehicle.

The cooler 200 is configured to be in contact with, for example, both plate surfaces of the power semiconductor package 110.

Here, the two plate surfaces of the power semiconductor package 110 refer to relatively wide surfaces on which the upper substrate 1102 and the lower substrate 1103 are respectively disposed
The cooler 200 is implemented as a plurality of units so as to be disposed along a thickness direction of the power semiconductor package 110 on both sides thereof.

The cooler 200 includes, for example, a lower cooler 201 disposed on one side (lower side in the drawing) of the power semiconductor package 110 and an upper cooler 202 disposed on the other side (upper side in the drawing) of the power semiconductor package 110.

The upper cooler 202 is, for example, in heat-exchangeable contact with the upper substrate 1102.

The lower cooler 201 is, for example, in heat-exchangeable contact with the lower substrate 1103.

A heat transfer material 205 is provided between mutual contact surfaces of the power semiconductor package 110 and the cooler 200.

Through this, an amount of air between the contact surfaces of the power semiconductor package 110 and the cooler 200 is reduced to allow the heat energy of the power semiconductor package 110 to be easily transferred to the cooler 200.

According to the configuration, cooling of the power semiconductor package 110 may be accelerated.

The heat transfer material 205 includes, for example, thermal grease or thermal compound.

The thermal grease or the thermal compound may be applied to each contact surface of the power semiconductor package 110 and/or the cooler 200, for example, prior to the coupling of the power semiconductor package 110 and/or the cooler 200, and then the power semiconductor package 110 and the cooler 200 may be pressed into close contact with each other. Accordingly, since the heat transfer material 205 is inserted into an empty space between the mutual contact surfaces of the power semiconductor package 110 and the cooler 200, an amount of air between the power semiconductor package 110 and the cooler 200 may be significantly reduced.

Through this, heat energy generated from the power semiconductor package 110 may be easily transferred to the cooler 200 (lower cooler 201, upper cooler 202).

Meanwhile, the heat transfer material 205 may include, for example, solder. By interposing the solder between the mutual contact surfaces of the power semiconductor package 110 and the cooler 200 and heating (soldering) the solder to melt, the molten solder may evenly permeate through a gap between the mutual contact surfaces of the power semiconductor package 110 and the cooler 200. Through this, an amount of air between the contact surfaces of the power semiconductor package 110 and the cooler 200 is reduced to allow the heat energy of the power semiconductor package 110 to be easily transferred to the cooler 200. In particular, since the solder is a metal, it has relatively excellent heat transfer characteristics to allow the heat energy of the power semiconductor package 110 to be more easily transferred to the cooler 200.

The cooler 200 (upper cooler 202, lower cooler 201) includes, for example, an inner plate 2001 that comes into contact with the power semiconductor package 110 and an outer plate 2002 disposed to be spaced apart from the inner plate 2001.

The inner plate 2001 and the outer plate 2002 of the cooler 200 may each be configured to have a longer length than a width thereof, for example.

Outer edges (rims) of the inner plate 2001 and the outer plate 2002 of the cooler 200 may be respectively provided with pin holes 207 into which pins (not shown) for determining positions during assembly are inserted, for example.

A passage 203 through which the cooling fluid moves is disposed inside the inner plate 2001 and the outer plate 2001 of the cooler 200.

The inner plate 2001 of the cooler 200 is configured to protrude to both sides (left and right sides in the drawing) along a plate surface direction of the power semiconductor package 110.

The outer plate 2002 of the cooler 200 is coupled to an outer surface of the inner plate 2001 to form a passage 203 through which the cooling fluid can move thereinside.

The outer plate 2002 of the cooler 200 is configured with, for example, a rectangular plate-shaped planar portion 20021 and a side wall portion 20022 that is bent along a rim of the planar portion 20021 and coupled in contact with a plate surface of the inner plate 2001.

Here, the inner plate 2001 and the outer plate 2002 may be, for example, bonded to each other. The inner plate 2001 and outer plate 2002 may be formed of, for example, a metal member. The inner plate 2001 and outer plate 2002 may be formed of, for example, an aluminum (Al) member.

The inner plate 2001 and the outer plate 2002 may be integrally joined to each other, for example, by brazing.

The upper cooler 202 is provided with the outer plate 2002 on an upper side of the inner plate 2001.

The lower cooler 201 is provided with the outer plate 2002 on a lower side of the inner plate 2001.

Meanwhile, the lower cooler 201 is provided with an inlet portion 20023 through which the cooling fluid flows in and an outlet portion 20024 through which the cooling fluid that has passed into the cooler 200 flows out.

The lower cooler 201 may be connected to a cooling fluid circulation circuit 400 in which the cooling fluid circulates, for example, as shown in FIG. 4.

An outlet-side end portion of the cooling fluid circulation circuit 400 may be connected to the inlet end portion, and an inlet-side end portion of the cooling fluid circulation circuit 400 may be connected to the outlet-side end portion.

The cooling fluid circulation circuit 400 is configured with a heat exchanger 401 in which the cooling fluid is cooled and a pump 402 that accelerates the movement of the cooling fluid.

Accordingly, the cooling fluid, whose temperature has increased through heat exchange with the power semiconductor package 110 while passing through the cooler 200, may be cooled while passing through the heat exchanger 401 of the cooling fluid circulation circuit 400.

The cooler 200 (upper cooler 202 and lower cooler 201) is configured with a heat dissipation fin 2003, one side of which is connected to the inner plate 2001 and the other side of which is connected to the outer plate 2002.

Through this, a contact area between the cooler 200 and the cooling fluid may be increased.

The heat dissipation fin 2003 may be disposed to correspond to a high heat generation portion of the power semiconductor package 110.

The heat dissipation fins 2003 may be configured to control an amount of heat exchange with the cooling fluid, for example, through the control of a size, a number, and spacing thereof.

That is, in order to increase the amount of heat exchange with the cooling fluid, the size and number of the heat dissipation fins 2003 may be increased, or the spacing therebetween may be reduced.

Through this, a local temperature of the power semiconductor package 110 may be suppressed from rising.

In this embodiment, the heat dissipation fin 2003 may be formed of a metal member.

The heat dissipation fin 2003 may be formed of, for example, an aluminum (Al) member.

The heat dissipation fin 2003 may be integrally coupled to the inner plate 2001 and the outer plate 2002 by brazing.

The heat dissipation fin 2003 may be formed, for example, by bending a long planar member.

The heat dissipation fin 2003 may be configured with, for example, a contact portion 20031 that comes into contact with the outer plate 2002 and a protruding portion 20032 having a rectangular cross-section that protrudes from the contact portion 20031 to come into contact with the inner plate 2001.

The heat dissipation fin 2003 is configured such that, for example, the contact portion 20031 and the protruding portion 20032 are mutually disposed alternately along one direction with a preset length.

The lower cooler 201 and upper cooler 202 are connected in communication with each other by the connecting member 300.

Accordingly, a movement direction of the cooling fluid of the lower cooler 201 and a movement direction of the cooling fluid of the upper cooler 202 are configured to be the same.

Through this, the occurrence of a temperature deviation between upper and lower surfaces of the power semiconductor package 110 may be suppressed.

The connecting member 300 is implemented in an extensible manner, for example.

The connecting member 300 may be implemented as a corrugated pipe.

The connecting member 300 is configured with, for example, tubular portions 3001 disposed to have a tubular shape on both sides thereof and a corrugated portion 3001 disposed to be extensible between the tubular portions 3001.

The connecting member 300 is disposed to be extensible along a thickness direction of the power semiconductor package 110.

In this embodiment, since a thickness direction of the power semiconductor package 110 is disposed in a top-bottom direction, the connecting member 300 may be extended and contracted along the top-bottom direction.

The connecting member 300 is configured to have a length that is significantly larger (e.g., 2 to 3 times) than a thickness of the power semiconductor package 110 when extended.

The connecting member 300 is configured to have a length corresponding to the thickness of the power semiconductor package 110 when contracted.

Each inner plate 2001 of the lower cooler 201 and upper cooler 202 is provided with a connecting member coupling portion 20011 to allow the connecting member 300 to be coupled thereto.

The connecting member coupling portion 20011 may be disposed to pass therethrough, for example, such that both end portions (tubular portions 3001) of the connecting member 300 may be inserted and coupled thereto.

In this embodiment, the lower cooler 201, the upper cooler 202 and the connecting member 300 may be integrally coupled to one another by brazing.

Through this, the occurrence of leakage of the cooling fluid may be suppressed.

With this configuration, the heat dissipation fin 2003 may be inserted between the inner plate 2001 and the outer plate 2002, and the inner plate 2001, the outer plate 2002, and the heat dissipation fin 2003 may be integrally coupled to one another by brazing.

When the lower cooler 201 and upper cooler 202 are respectively manufactured, the connecting member 300 may be disposed between the lower cooler 201 and upper cooler 202.

An upper portion of the connecting member 300 may be inserted and coupled to the connecting member insertion portion 20011 of the upper cooler 202, and a lower portion thereof may be inserted and connected to the connecting member insertion portion 20011 of the lower cooler 201.

Here, the connecting member 300 may be connected to the lower cooler 201 and the upper cooler 202, respectively, in an extended state, as shown in FIG. 2.

The connecting member 300, the lower cooler 201 and the upper cooler 202 may be integrally coupled to one another by brazing.

Meanwhile, when the coupling of the connecting member 300, the lower cooler 201 and the upper cooler 202 is completed, the power semiconductor package 110 may be inserted and coupled between the lower cooler 201 and the upper cooler 202.

Here, the heat transfer material 205 may be inserted between mutual contact surfaces of the power semiconductor package 110 and the upper cooler 202, and mutual contact surfaces of the power semiconductor package 110 and the lower cooler 201.

When the heat transfer material 205 is interposed in mutual contact regions between the power semiconductor package 110 and the lower cooler 201 and the upper cooler 202, the lower cooler 201 and the upper cooler 202 may be pressed and contracted along a thickness direction of the power semiconductor package 110.

Here, the lower cooler 201 and the upper cooler 202 may be pressed to a degree that the lower cooler 201 and the upper cooler 202 can be in close contact with both side plate surfaces of the power semiconductor package 110.

Accordingly, an amount of air in the mutual contact regions between the power semiconductor package 110 and the lower cooler 201, and between the power semiconductor package 110 and the upper cooler 202 may be significantly reduced.

Through this, heat energy generated in the power semiconductor package 110 may be quickly transferred to the lower cooler 201 and the upper cooler 202.

Meanwhile, the inlet portion 20023 and outlet portion 20024 of the lower cooler 201 may be connected to the cooling fluid circulation circuit 400, as shown in FIG. 4. The cooling fluid circulation circuit 400 is configured with a heat exchanger 401 in which the cooling fluid is cooled through heat exchange and a pump 402 that accelerates the movement (circulation) of the cooling fluid.

When an operation is initiated, heat energy is generated by the heat generation of the power semiconductor package 110, thereby causing the temperature to rise.

The heat energy generated in the power semiconductor package 110 is transferred to the lower cooler 201 and the upper cooler 202.

When an operation is initiated, the pump 402 of the cooling fluid circulation circuit 400 is operated, and the cooling fluid is circulated along the cooling fluid circulation circuit 400.

The cooling fluid of the cooling fluid circulation circuit 400 is cooled while passing through the heat exchanger 401.

The cooling fluid cooled while passing through the heat exchanger 401 flows into the lower cooler 201 through the inlet portion 20023.

Part of the cooling fluid flowing into the inlet portion 20023 moves downstream to absorb heat energy while passing through the heat dissipation fin 2003 of the lower cooler 201, and moves toward the outlet portion 20024 with an increased temperature.

Another part of the cooling fluid flowing into the inlet portion 20023 moves to the upper cooler 202 through the connecting member 300 provided on a side of the inlet portion 20023.

The cooling fluid moved to the upper cooler 202 absorbs heat energy while passing through the heat dissipation fin 2003 of the upper cooler 202 to increase in temperature, and moves to the outlet portion 20024 by way of the connecting member 300 on a side of the outlet portion 20024.

The cooling fluid, whose temperature has increased by absorbing the heat energy of the power semiconductor package 110, moves to the outlet portion 20024 to absorb and cool the heat energy generated in the power semiconductor package 110 while repeating a process of circulating and cooling along the cooling fluid circulation circuit 400 through the outlet portion 20024.

Meanwhile, when an operation is initiated and the power semiconductor package 110 undergoes thermal expansion (contraction) along a thickness direction, the connecting member 300 absorbs deformation while extending (contracting) along a thickness direction (top-bottom direction in the drawing) of the power semiconductor package 110.

Accordingly, the occurrence of damage to the power semiconductor package 110, the lower cooler 201, and the upper cooler 202 may be suppressed.

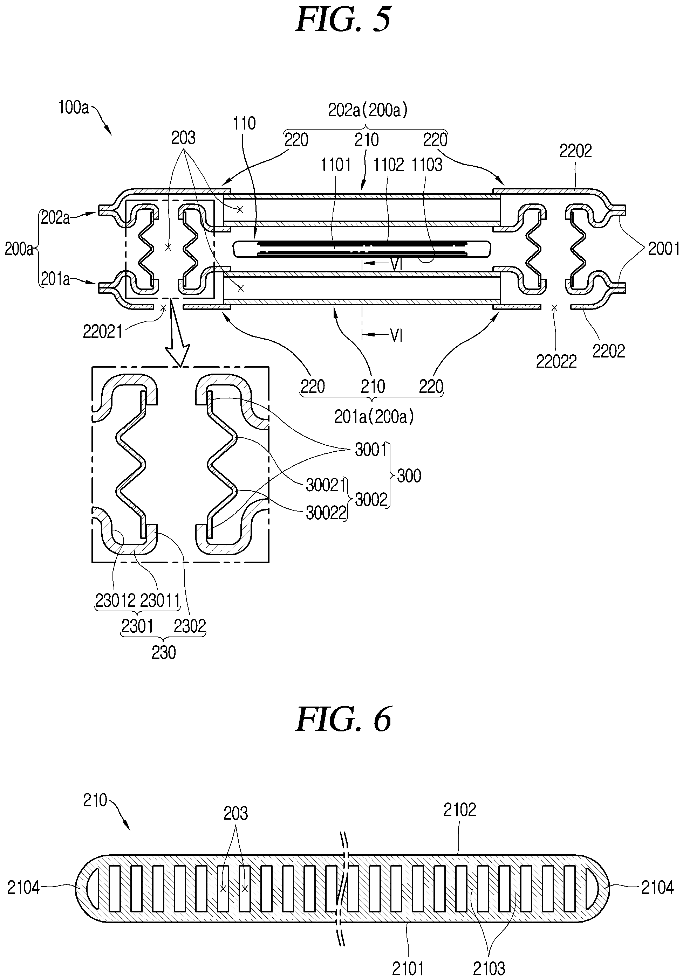

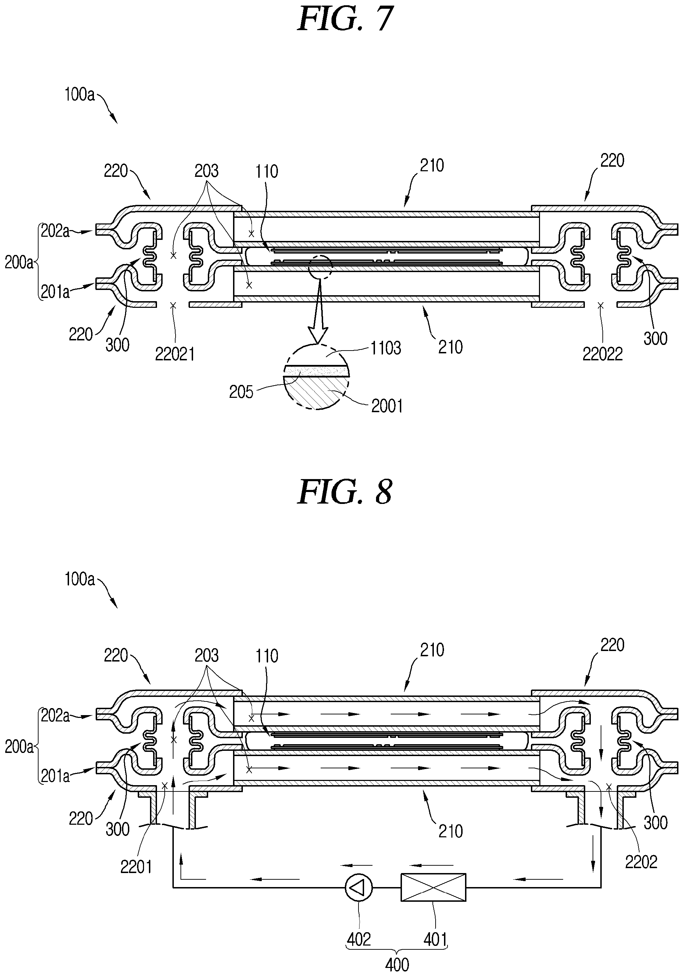

FIG. 5 is a cross-sectional view of a modified example of the double-side cooling power semiconductor package of FIG. 1, FIG. 6 is a cross-sectional view of a cooler in FIG. 5, FIG. 7 is a cross-sectional view of a compressed state of a connecting member in FIG. 5, and FIG. 8 is a view for explaining an operation of the double-side cooling power semiconductor package of FIG. 7.

As shown in FIGS. 5 to 7, a double-side cooling power semiconductor package 100a in this embodiment includes a power semiconductor package 110, a cooler 200a, and a connecting member 300.

The power semiconductor package 110 is configured with, for example, a plurality of circuit elements 1101, an upper substrate 1102 provided on an upper side of the plurality of circuit elements 1101, and a lower substrate 1103 provided on a lower side of the plurality of circuit elements 1101.

A plurality of power leads 1104 are provided on one side of the power semiconductor package 110.

A plurality of signal leads 1105 are provided on the other side (opposite side) of the power semiconductor package 110.

The cooler 200a is implemented as a plurality of units provided along a thickness direction of the power semiconductor package 110 on both sides thereof.

Specifically, the plurality of coolers 200a include a lower cooler 201a disposed on a lower side of the power semiconductor package 110 and an upper cooler 202a disposed on an upper side of the power semiconductor package 110.

The plurality of coolers 200a are configured with, for example, bodies 210, respectively, in which a passage 203 of cooling fluid is disposed thereinside.

The body 210 is configured with, for example, an inner plate 2101 that comes into contact with the power semiconductor package 110, an outer plate 2102 disposed to be spaced apart from the inner plate 2101, and partition 2103s, one sides of which are connected to the inner plate 2101 and the other sides of which are connected to the outer plate 2102, as shown in FIG. 6.

Accordingly, the body 210 of the cooler 200a may be extruded, to easily perform mass production.

Two side walls 2104 of the body 210 may be implemented, for example, in an outwardly convex circular cross-sectional shape.

The plurality of coolers 200a (the lower cooler 201a and the upper cooler 202a) includes headers 220 provided at inlet-side and outlet-side end portions thereof, respectively.

The header 220 is configured with, for example, an inner plate 2201 and an outer plate 2202 that are spaced apart from each other along a thickness direction of the power semiconductor package 110 to form a passage 203 of cooling fluid thereinside.

One side of the header 220 is provided with a body coupling portion 2203 to which the body 210 is coupled.

The body coupling portion 2203 may be disposed to be open to the outside, for example, so as to allow an end portion of the body 210 to be inserted thereinto.

The header 220 provided on an inlet side of the lower cooler 201a is provided with an inlet portion 22021 through which the cooling fluid flows in.

The inlet portion 22021 is disposed on the outer plate 2202 of the inlet-side header 220 of the lower cooler 201a to pass therethrough.

The header 220 provided on an outlet-side of the lower cooler 201a is provided with an outlet portion 22022 through which the cooling fluid flows out.

The outlet portion 22022 is disposed on the outer plate 2202 of the outlet-side header 220 of the lower cooler 201a to pass therethrough.

Meanwhile, the connecting member 300 is vertically disposed between the header 220 of the lower cooler 201a and the header 220 of the upper cooler 202a.

The lower cooler 201a and the upper cooler 202a are connected in communication with each other by the connecting member 300.

Accordingly, the movement direction of the cooling fluid of the lower cooler 201a and that of the upper cooler 202a are configured to be the same.

Through this, the occurrence of a temperature deviation between lower and upper surfaces of the power semiconductor package 110 may be suppressed.

Specifically, the connecting member 300 is provided between the inlet-side header 220 of the upper cooler 202a and the inlet-side header 220 of the lower cooler 201a, and between the outlet-side header 220 of the upper cooler 202a and the outlet-side header 220 of the lower cooler 201a.

The connecting member 300 is configured with, for example, tubular portions 3001 provided in a tubular shape on both sides thereof, and a corrugated portion 3002 disposed to be extensible between the tubular portions 3001.

Accordingly, when the power semiconductor package 110 undergoes thermal expansion, the connecting member 300 (the corrugated portion 3002) may absorb the deformation, thereby suppressing damage to the power semiconductor package 110, the lower cooler 201a, and the upper cooler 202a from occurring.

In this embodiment, the connecting member 300 may be configured to have a circular or elliptical cross-section.

The corrugated portion 3002 may be configured with, for example, a circular or elliptical cross-section.

In this embodiment, the tubular portion 3001 and the corrugated portion 3002 may be configured with an elliptical cross-sectional shape having a transversely long length in the movement direction of the cooling fluid.

The corrugated portion 3002 is configured with, for example, a top portion 30021 having a maximum outer width and a bottom portion 30022 having a minimum outer width.

The bottom portion 30022 is disposed between the top portions 30021 along an extension direction.

In this embodiment, the body 210, the header 220, and the connecting member 300 may be respectively formed of a metal member (e.g., an aluminum (Al) member).

The respective headers 220 are respectively provided with connecting member coupling portions 230 to which the connecting members 300 are coupled to overlap along a thickness direction of the power semiconductor package 110.

Through this, a length of the corrugated portion 3002 of the connecting member 300 may be sufficiently secured so as to easily perform the extension and contraction of the connecting member 300.

The connecting member coupling portion 230 includes, for example, a recessed portion 2301 that is recessed in a thickness direction so as to receive an end portion of the connecting member 300.

Accordingly, the connecting member 300 may be prevented from being excessively compressed during the contraction of the connecting member 300.

In this embodiment, the connecting member 300 is manufactured in an extended state (see FIG. 5).

The connecting member 300 may be contracted such that the lower cooler 201a and the upper cooler 202a may respectively come into contact with both plate surfaces of the power semiconductor package 110 (see FIG. 7).

The recessed portions 2301 are disposed to have the headers 220, respectively, to allow both end portions of the connecting member 300 to be received into the recessed portions 2301, and thus have a relatively long length even after contraction. Accordingly, the corrugated portion 3002 may be prevented from being excessively compressed during the contraction of the connecting member 300.

The recessed portion 2301 has an inner width that is larger than a maximum outer width of the connecting member 300 (an outer width of the corrugated portion 3002).

Through this, during the contraction of the connecting member 300, an outermost region (the corrugated portion 3002) may be received into the recessed portion 2301 along a width direction of the connecting member 300 without interfering with the recessed portion 2301.

In this embodiment, the recessed portion 2301 is implemented in, for example, an elliptical cross-sectional shape.

Specifically, the recessed portion 2301 includes a recessed bottom portion 23011 that is recessed in a thickness direction from the inner plate 2202 and an outer wall portion 23012 that is disposed in a cylindrical shape with an elliptical cross-section from an outer rim of the recessed bottom portion 23011.

The connecting member coupling portion 230 includes an overlapping section 2302 that protrudes from the recessed portion 2301 to overlap in a length direction with an end portion (the tubular portion 3001) of the connecting member 300.

Through this, during the contraction of the connecting member 300, the corrugated portion 3002 of the connecting member 300 may be prevented from coming into contact with the recessed bottom portion 23011 along a length direction of the connecting member 300.

The overlapping section 2302 is provided at the center of the recessed portion 2301 (recessed bottom portion 23011).

The overlapping section 2302 may be referred to as an "inner wall section" in that it is provided on an inner side of the recessed portion 2301 (recessed bottom portion 23011).

The overlapping section 2302 has, for example, an elliptical cross-sectional shape to correspond to a shape of the tubular portion 3001 of the connecting member 300.

In this embodiment, a protruding length of the overlapping section 2302 is configured to be smaller than a depth of the recessed portion 2301.

Accordingly, the occurrence of a contact between the corrugated portion 3002 and the recessed portion 2301 during the contraction of the connecting member 300 may be suppressed.

The body 210 and header 220 of the cooler 200a may be connected to each other by brazing.

The cooler 200a (header 220) and the connecting member 300 may be connected to each other by brazing.

Through this, a bonding strength between the cooler 200a and the connecting member 300 may be improved.

In addition, the cooling fluid may be prevented from leaking between the cooler 200a and the connecting member 300.

With this configuration, when the lower cooler 201a and the upper cooler 202a are manufactured, the upper cooler 202a may be disposed on an upper side of the lower cooler 201a to be spaced apart therefrom.

The connecting member 300 may be disposed between the header 220 of the lower cooler 201a and the header 220 of the upper cooler 202a.

Here, the respective connecting members 300 are respectively coupled between the lower cooler 201a and the upper cooler 202a in an extended state, as shown in FIG. 5.

Meanwhile, a heat transfer material 205 may be interposed in mutual contact regions between the power semiconductor package 110 and the lower cooler 201a and the upper cooler 202a, and then the lower cooler 201a and the upper cooler 202a may be pressed and contracted in contact with both plate surfaces (upper and lower surfaces in the drawing) of the power semiconductor package 110.

Accordingly, the corrugated portion 3002 of each connecting member 300 is contracted, and an upper surface of the lower cooler 201a and a lower surface of the upper cooler 202a are in close contact with lower and upper surfaces of the power semiconductor package 110, respectively.

The inlet portion 22021 and outlet portion 22022 of the lower cooler 201a may be respectively connected to the cooling fluid circulation circuit 400 through which the cooling fluid circulates.

The cooling fluid circulation circuit 400 is provided with a heat exchanger 401 in which the cooling fluid is cooled.

The cooling fluid circulation circuit 400 is provided with a pump 402 that accelerates the movement of the cooling fluid.

The inlet portion 22021 of the lower cooler 201a is connected to a downstream side (outlet side) of the heat exchanger 401 with respect to a movement direction of the cooling fluid circulated by the pump 402.

The outlet portion 22022 of the lower cooler 201a is connected to an upstream side (inlet side) of the heat exchanger 401.

When an operation is initiated, the temperature rises due to the heat generation of the power semiconductor package 110, and heat energy generated from the power semiconductor package 110 moves to the lower cooler 201a and the upper cooler 202a, respectively.

When an operation is initiated, the pump 402 is operated, and the cooling fluid cooled in the heat exchanger 401 flows into the inlet portion 22021 of the lower cooler 201a.

Part of the cooling fluid flowing into the inlet portion 22021 absorbs heat energy generated from the power semiconductor package 110 while passing through an inside of the lower cooler 201a and moves to the outlet portion 22022 with an increased temperature.

Another part of the cooling fluid flowing into the inlet portion 22021 moves to the upper cooler 202a through the connecting member 300 in proximity to the inlet portion 22021. The cooling fluid moved to the upper cooler 202a absorbs heat energy generated from the power semiconductor package 110 to increase in temperature, and moves to the outlet portion 22022 by way of the connecting member 300 provided in proximity to the outlet portion 22022.

The cooling fluid, whose temperature has increased by way of the lower cooler 201a and upper cooler 202a, continuously cools the power semiconductor package 110 while repeating a process of moving to the cooling fluid circulation circuit 400 through the outlet portion 22022, cooling in the heat exchanger 401, and then flowing into the inlet portion 22021 of the lower cooler 201a.

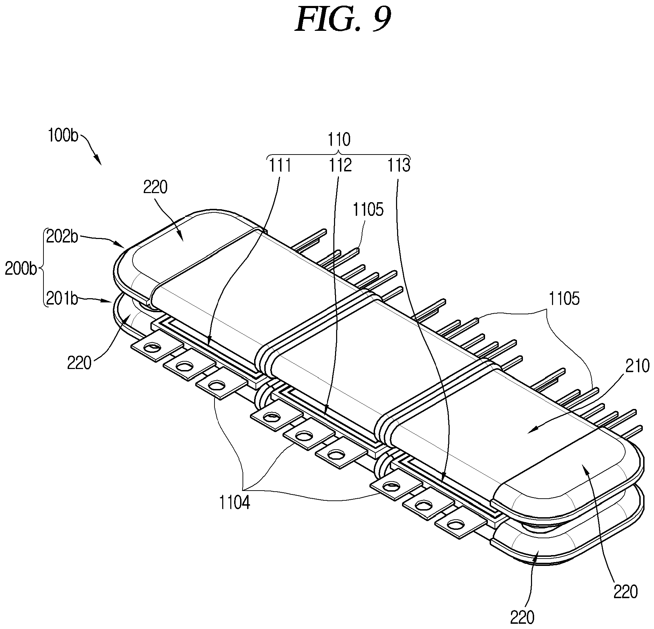

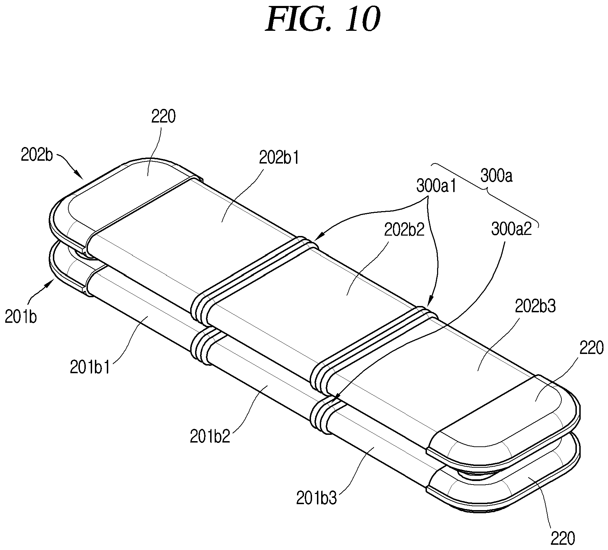

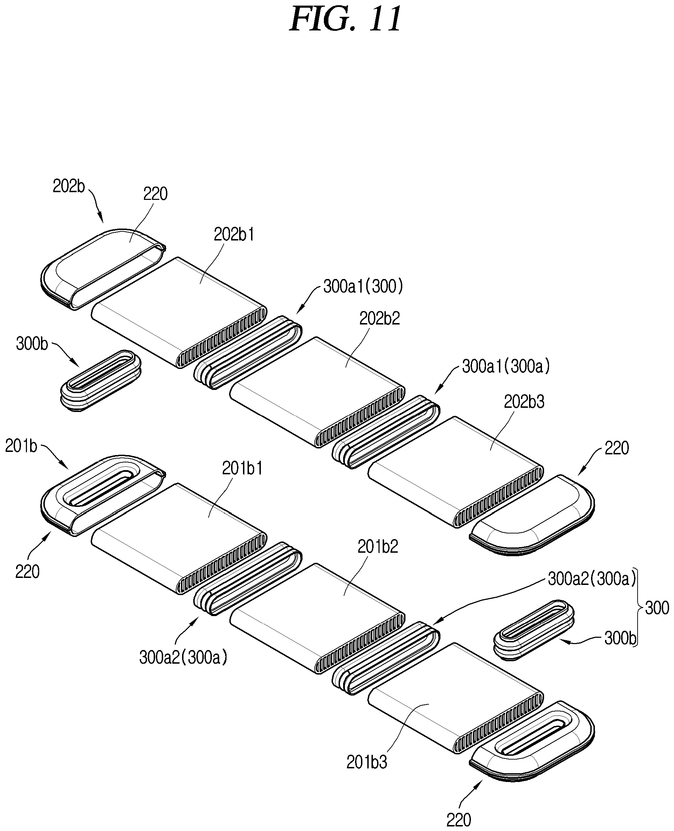

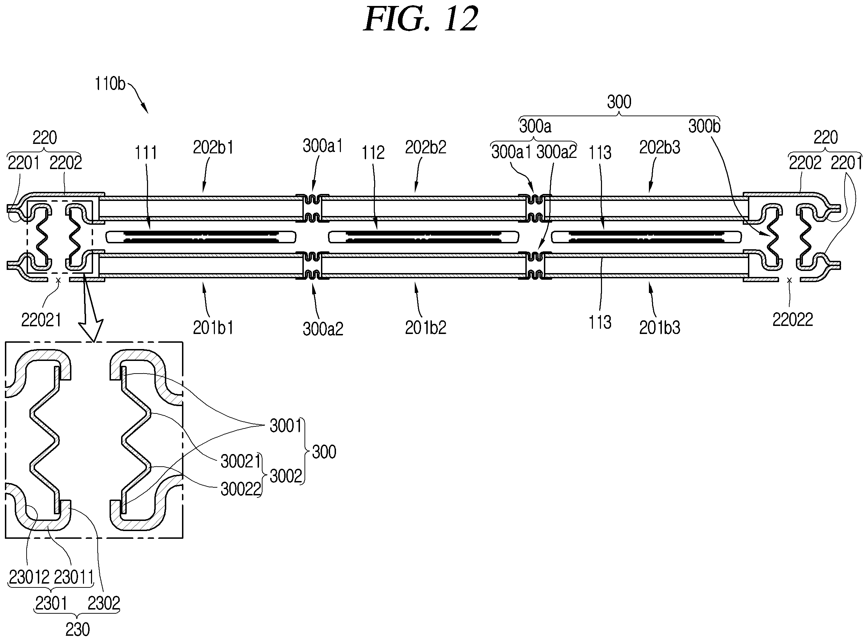

FIG. 9 is a perspective view of a double-side cooling power semiconductor package according to another embodiment of the present disclosure, FIG. 10 is a perspective view of an upper cooler and a lower cooler in FIG. 9, FIG. 11 is an exploded perspective view of the upper cooler and the lower cooler of FIG. 10, and FIG. 12 is a cross-sectional view prior to the contraction of a vertical connecting member of the double-side cooling power semiconductor package of FIG. 9.

As shown in FIGS. 9 to 12, a double-side cooling power semiconductor package 100b in this embodiment includes a power semiconductor package 110, a cooler 200b, and a connecting member 300.

The power semiconductor package 110 is configured with a plurality of circuit elements 1101, an upper substrate 1102 provided on an upper side of the plurality of circuit elements 1101, and a lower substrate 1103 provided on a lower side of the plurality of circuit elements 1101.

A plurality of power leads 1104 are provided on one side of the power semiconductor package 110.

A plurality of signal leads 1105 are provided on the other side (opposite side) of the power semiconductor package 110.

The power semiconductor package 110 may be configured with a plurality of units, for example, so as to be spaced apart from one another along a plate surface direction.

The power semiconductor package 110 is configured with, for example, a first power semiconductor package 111, a second power semiconductor package 112, and a third power semiconductor package 113 spaced apart from one another along a plate surface direction.

The cooler 200b is provided with a passage 203 of cooling fluid thereinside, and configured with a plurality of units so as to be respectively provided on both sides (upper and lower sides in the drawing) of the power semiconductor package 110.

The cooler 200b includes, for example, a lower cooler 201b provided on a lower side of the power semiconductor package 110 and an upper cooler 202b provided on an upper side thereof.

In this embodiment, the lower cooler 201b is configured to be heat-exchangeable on lower sides of the first power semiconductor package 111, the second power semiconductor package 112, and the third power semiconductor package 113, respectively.

The lower cooler 201b is configured with, for example, three lower coolers such as a first lower coolers 201b1, a second lower coolers 201b2, and a third lower coolers 201b3, which are respectively in heat-exchangeable contact with lower surfaces of the first power semiconductor package 111, the second power semiconductor package 112, and the third power semiconductor package 113.

The upper cooler 202b is configured to be heat-exchangeable on upper sides of the first power semiconductor package 111, the second power semiconductor package 112, and the third power semiconductor package 113.

The upper cooler 202b is configured with, for example, three upper coolers such as a first upper coolers 202b1, a second upper coolers 202b2, and a third upper coolers 202b3, which are respectively in heat-exchangeable contact with upper surfaces of the first power semiconductor package 111, the second power semiconductor package 112, and the third power semiconductor package 113.

In this embodiment, the lower cooler 201b and the upper cooler 202b are respectively configured with a body 210 having the same structure.

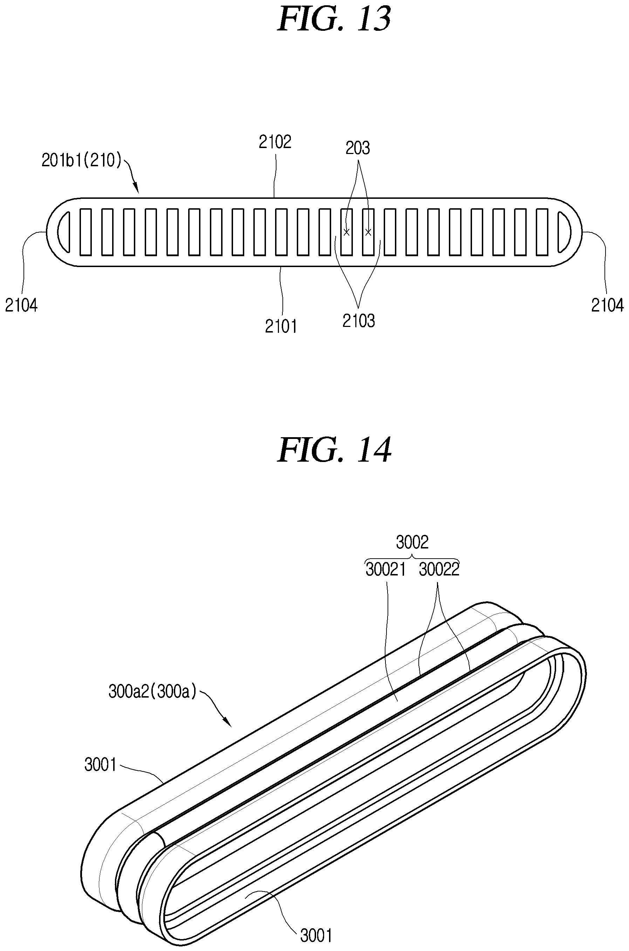

FIG. 13 is a front view of a body of the cooler (lower cooler) in FIG. 11. As shown in FIG. 13, the body 210 of the lower cooler 201b is configured with an inner plate 2101 that comes into contact with a plate surface of the power semiconductor package 110, an outer plate 2102 disposed to be spaced apart from the inner plate 2101, and a partition 2103 one end of which is connected to the inner plate 2101 and the other end of which is connected to the outer plate 2102.

The partition 2103 is implemented as a plurality of units spaced apart parallel to one another.

Both side walls 2104 connecting the inner plate 2101 and the outer plate 2102 may be implemented in an outwardly convex curved cross-sectional shape.

Accordingly, the body 210 of the cooler 200 may be easily manufactured by extrusion.

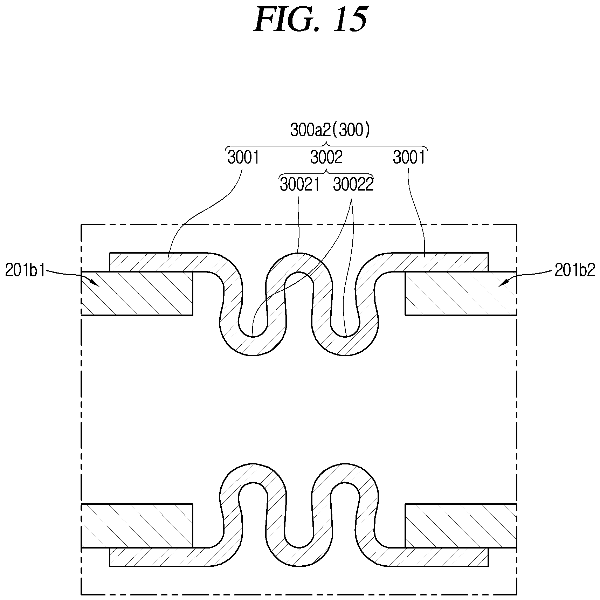

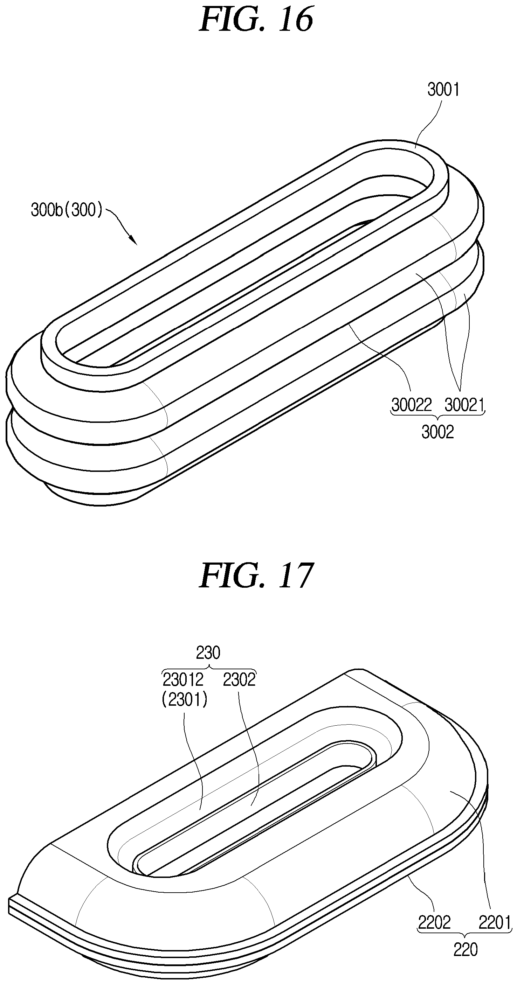

FIG. 14 is a perspective view of a horizontal connecting member (upper horizontal connecting member) in FIG. 11, FIG. 15 is an enlarged view of a region of the horizontal connecting member (upper horizontal connecting member) in FIG. 12, FIG. 16 is a perspective view of a vertical connecting member in FIG. 11, and FIG. 17 is an enlarged view of a region of the vertical connecting member of FIG. 12.

As shown in FIGS. 14 to 17, the connecting member 300 includes the passage 203 of cooling fluid thereinside, and is connected in communication with the plurality of coolers 200.

The connecting member 300 is disposed to be extensible.

Specifically, the connecting member 300 is configured in a corrugated pipe shape.

The connecting member 300 is configured to have, for example, an elliptical cross-sectional shape.

The connecting member 300 is configured with, for example, tubular portions 3001 disposed to have an elliptical cross-sectional shape on both sides thereof and a corrugated portion 3002 disposed to be extensible between the tubular portions 3001.

The connecting member 300 includes a horizontal connecting member 300a that connects the three bodies 210 along a horizontal direction.

The horizontal connecting member 300a is configured with, for example, a plurality of upper horizontal connecting members 300a1 that horizontally connect the bodies 210 of the upper cooler 202b.

The horizontal connecting member 300a includes, for example, a plurality of lower horizontal connecting members 300a2 that horizontally connect the bodies 210 of the lower cooler 201b.

In this embodiment, the tubular portion 3001 of the horizontal connecting member 300a (upper horizontal connecting member 300a1, lower horizontal connecting member 300a2) is configured to be open to the outside so as to allow an end portion of the body 210 to be inserted thereinto.

The body 210 and horizontal connecting member 300a (upper horizontal connecting member 300a1, lower horizontal connecting member 300a2) may each be formed of a metal member (e.g., an aluminum (Al) member).

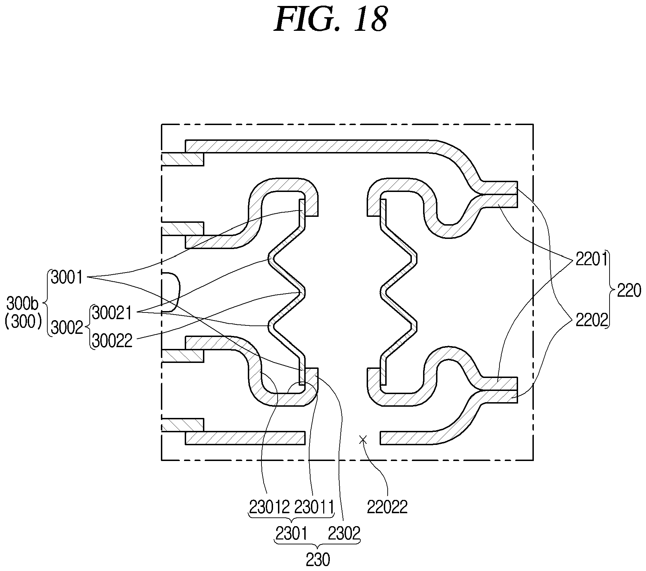

FIG. 18 is a perspective view of an outlet-side header in FIG. 11. As shown in FIGS. 12, 17 and 18, the cooler 200 includes headers 220 provided at inlet-side and outlet-side end portions of the lower cooler 201b and the upper cooler 202b, respectively.

Here, the header 220 provided at the inlet-side end portion of the cooler 200 may be referred to as an inlet-side header 220, and the header 220 provided at the outlet-side end portion of the cooler 200 may be referred to as an outlet-side header 220.

The respective headers 220 are configured respectively with, for example, an inner plate 2201 and an outer plate 2202 that are spaced apart from each other along a thickness direction of the power semiconductor package 110 to form a passage 203 of cooling fluid thereinside.

The header 220 may be formed of a metal member (e.g., an aluminum member).

The header 220 of the lower cooler 201b and the header 220 of the upper cooler 202b are spaced apart from each other along a thickness direction (a top-bottom direction in the drawing) of the power semiconductor package 110.

The header 220 of the lower cooler 201b and the header 220 of the upper cooler 202b may be connected in communication with each other by the connecting member 300.

The connecting member 300 includes a vertical connecting member 300b that is vertically disposed between the header 220 of the lower cooler 201b and the header 220 of the upper cooler 202b.

Specifically, an inlet-side vertical connecting member 300b may be provided between the inlet-side headers 220, and an outlet-side vertical connecting member 300b may be provided between the outlet-side headers 220.

Through this, the lower cooler 201b and the upper cooler 202b may be connected in parallel with each other.

A movement direction of the cooling fluid of the lower cooler 201b and a movement direction of the upper cooler 202b are configured to be the same.

According to this configuration, the occurrence of temperature deviations between low and upper surfaces of the first power semiconductor package 111, the second power semiconductor package 112, and the third power semiconductor package 113 may be respectively suppressed.

The headers 220 are respectively provided with connecting member coupling portions 230 to which the connecting members 300 (vertical connecting members 300b) are coupled.

The connecting member coupling portion 230 of the header 220 is configured to be coupled in an overlapping manner along a thickness direction of the power semiconductor package 110.

The connecting member coupling portion 230 of the header 220 includes a recessed portion 2301 that is recessed in a thickness direction to receive an end portion of the connecting member 300 (vertical connecting member 300b).

The recessed portion 2301 includes an inner width that is larger than a maximum outer width of the connecting member 300 (vertical connecting member 300b).

The recessed portion 2301 is configured with, for example, a recessed bottom portion 23011 that is recessed along a thickness direction of the power semiconductor package 110 and a side wall portion 23012 having an inner width greater than a maximum outer width of the connecting member 300 (vertical connecting member 300b).

The connecting member coupling portion 230 includes an overlapping section 2302 that protrudes from the recessed portion 2301 to overlap in a length direction with an end portion of the connecting member 300 (vertical connecting member 300b).

The overlapping section 2302 is configured to protrude from the recessed bottom portion 23011.

The overlapping section 2302 is configured to be inserted into the tubular portion 3001 of the connecting member 300 (vertical connecting member 300).

The overlapping section 2302 includes, for example, an outer surface that comes into surface contact with an inner surface of the tubular portion 3001 of the connecting member 300 (vertical connecting member 300b).

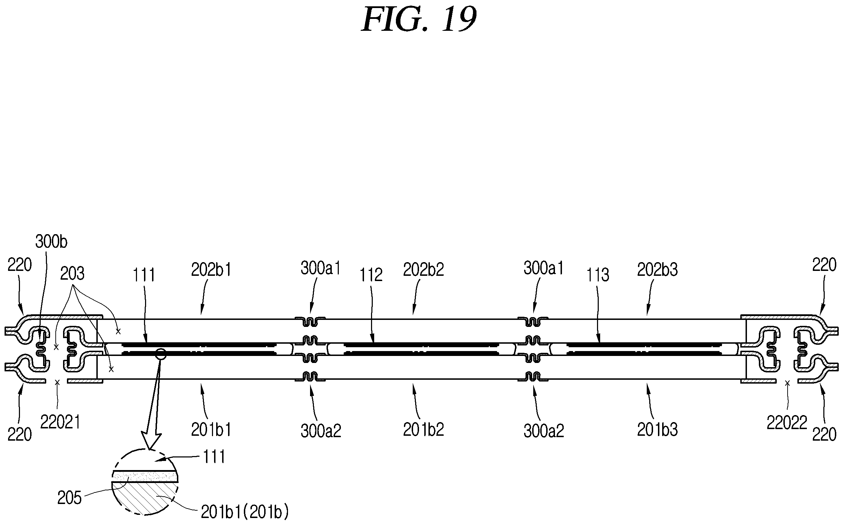

FIG. 19 is a cross-sectional view subsequent to the contraction of the vertical connecting member of the double-side cooling power semiconductor package of FIG. 12. As shown in FIG. 19, both end portions (tubular portions 3001) of the vertical connecting member 300b in an extended state are connected to the header 220 of the lower cooler 201b and the header 220 of the upper cooler 202b, respectively.

In this embodiment, the header 220 and the vertical connecting member 300b may be integrally coupled to each other by brazing.

An insertion space for the power semiconductor package 110 is disposed between the lower cooler 201b and the upper cooler 202b.

The power semiconductor package 110 (the first power semiconductor package 111, the second power semiconductor package 112, and the third power semiconductor package 113) may be inserted between the lower cooler 201b and the upper cooler 202b.

In this case, a heat transfer material 205 may be inserted into mutual contact surfaces between the power semiconductor package 110 (the first power semiconductor package 111, the second power semiconductor package 112, and the third power semiconductor package 113) and the cooler 200 (the lower cooler 201b and the upper cooler 202b), respectively.

When the power semiconductor package 110 is inserted, the vertical connecting member 300b may be pressed and contracted to allow the power semiconductor package 110 and the cooler 200 to come into contact with each other.

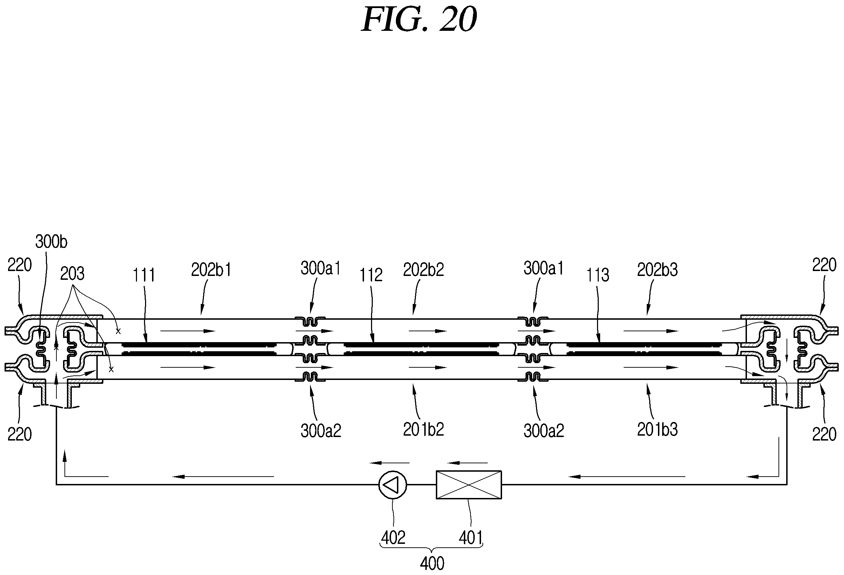

FIG. 20 is a view for explaining an operation of the double-side cooling power semiconductor package of FIG. 17. As shown in FIG. 20, the inlet portion 22021 and outlet portion 22022 of the lower cooler 201b may be connected to the cooling fluid circulation circuit 400.

The cooling fluid circulation circuit 400 includes a heat exchanger 401 in which the cooling fluid is cooled through heat exchange.

The cooling fluid circulation circuit 400 is provided with a pump 402 that accelerates the movement of the cooling fluid.

The inlet portion 22021 of the lower cooler 201b is connected to an outlet side of the heat exchanger 401 with respect to a movement direction of the cooling fluid moved by the pump 402.

In addition, the outlet portion 22022 of the lower cooler 201b is connected to an inlet side of the heat exchanger 401 with respect to a movement direction of the cooling fluid moved by the pump 402.

With this configuration, when an operation is initiated, the power semiconductor packages 110 (the first power semiconductor package 111, the second power semiconductor package 112, and the third power semiconductor package 113) respectively generate heat energy through heat generation.

At this time, when the power semiconductor package 110 undergoes thermal deformation (expansion) along a thickness direction, the deformation may be absorbed by the extension of the vertical connecting member 300b.

Furthermore, thermal deformation (expansion) along a plate surface direction of the power semiconductor package 110 may be absorbed by contraction of the upper horizontal connecting member 300a1.

Thermal energy generated from the power semiconductor package 110 moves to the lower cooler 201b and the upper cooler 202b, respectively.

Meanwhile, when an operation is initiated, the pump 402 is operated to allow the cooling fluid to circulate through the cooling fluid circulation circuit 400 and the cooler 200 (lower cooler 201b, upper cooler 202b).

The cooling fluid of the cooling fluid circulation circuit 400 is cooled through heat exchange while passing through the heat exchanger 401.

The cooling fluid passing through the heat exchanger 401 moves to the inlet portion 22021 of the lower cooler 201b.

Part of the cooling fluid flowing in through the inlet portion 22021 moves along an inside of the lower cooler 201b (body 210 and lower horizontal connecting member 300a2). At this time, the cooling fluid of the lower cooler 201b absorbs heat energy generated in the power semiconductor package 110 to increase in temperature.

Another part of the cooling fluid flowing in through the inlet portion 22021 moves to the upper cooler 202b by way of the vertical connecting member 300b in proximity to the inlet portion 22021.

The cooling fluid moved to the upper cooler 202b moves along an inside of the upper cooler 202b (body 210 and upper horizontal connecting member 300a1).

The cooling fluid passing through an inside of the upper cooler 202b is heated to increase in temperature and moves to the outlet portion 22022 by way of the outlet-side header 220 and the outlet-side vertical connecting member 300b.

The cooling fluid, whose temperature has increased, flowing out to an outside of the lower cooler 201b through the outlet portion 22022 is cooled by dissipating heat while passing through the heat exchanger 401.

The cooling fluid cooled in the heat exchanger 401 continuously cools the power semiconductor package 110 while repeating a process of flowing into the inlet portion 22021 of the lower cooler 201b and absorbing heat energy while passing through the lower cooler 201b and the upper cooler 202b.

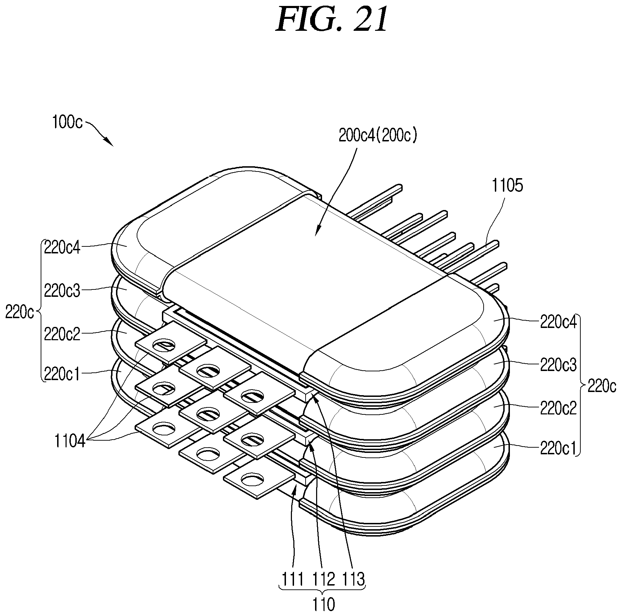

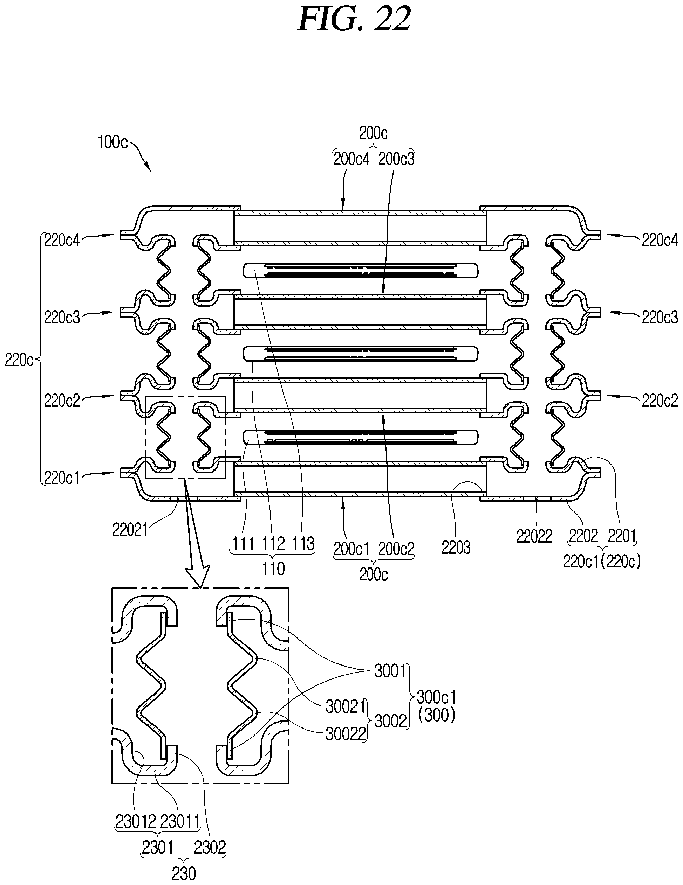

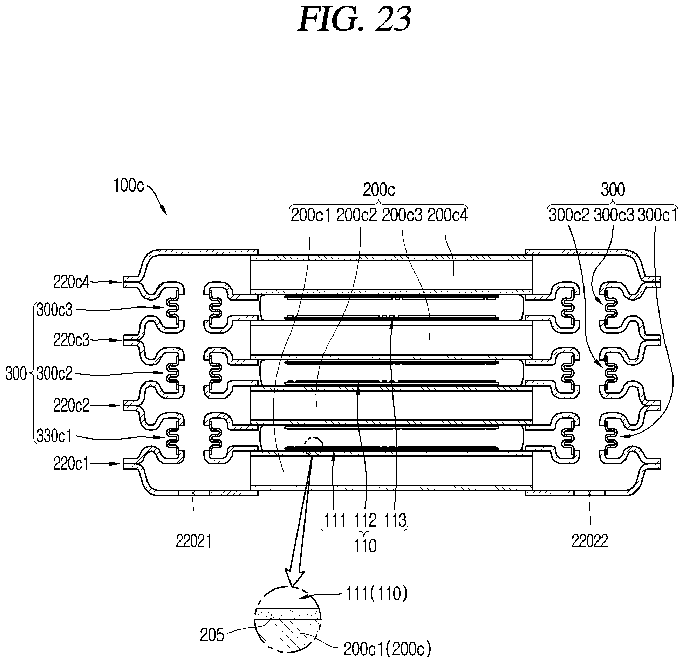

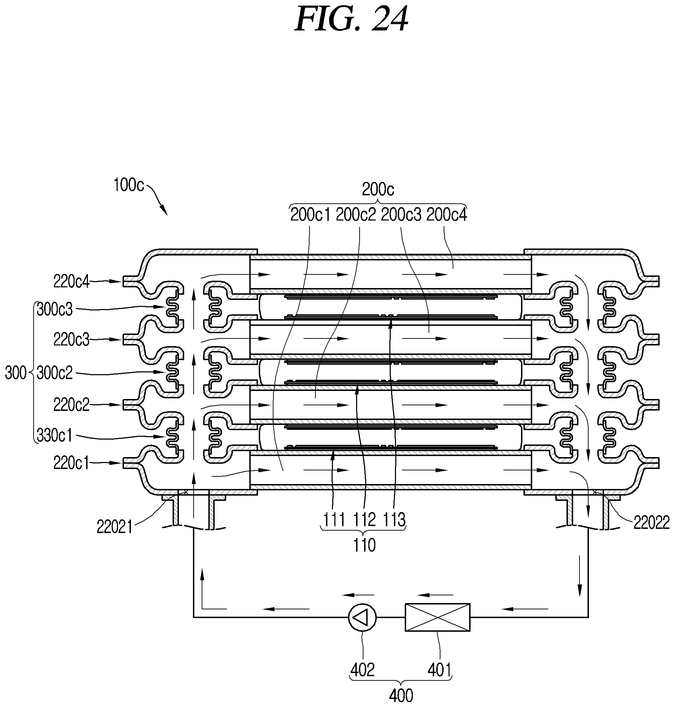

FIG. 21 is a perspective view of a double-side cooling power semiconductor package according to still another embodiment of the present disclosure, FIG. 22 is a cross-sectional view prior to the contraction of a connecting member of the double-side cooling power semiconductor package of FIG. 21, FIG. 23 is a cross-sectional view subsequent to the contraction of the connecting member of the double-side cooling power semiconductor package of FIG. 21, and FIG. 24 is a view for explaining an operation of the double-side cooling power semiconductor package of FIG. 22.

As shown in FIGS. 21 to 24, a double-side cooling power semiconductor package 100c in this embodiment includes a power semiconductor package 110, a cooler 200c, and a connecting member 300.

The power semiconductor package 110 is configured with a plurality of circuit elements 1101, an upper substrate 1102 provided on an upper side of the plurality of circuit elements 1101, and a lower substrate 1103 provided on a lower side of the plurality of circuit elements 1101.

A plurality of power leads 1104 are provided on one side of the power semiconductor package 110.

A plurality of signal leads 1105 are provided on the other side (opposite side) of the power semiconductor package 110.

In this embodiment, the power semiconductor package 110 is implemented as a plurality of units disposed to be spaced apart from one another along a thickness direction.

The power semiconductor package 110 is configured with, for example, a first power semiconductor package 111, a second power semiconductor package 112, and a third power semiconductor package 113 spaced apart from one another along a thickness direction.

The cooler 200c is provided with a passage 203 of cooling fluid thereinside, and configured to be in contact with both sides (lower and upper sides in the drawing) of the power semiconductor package 110.

Specifically, the cooler 200c includes a first cooler 200c1 disposed on a lower side of the first power semiconductor package 111, a second cooler 200c2 disposed on an upper side of the first power semiconductor package 111, a third cooler 200c3 disposed on an upper side of the second power semiconductor package 112, and a fourth cooler 200c4 disposed on an upper side of the third power semiconductor package 113.

The cooler 200c(first cooler 200c1, second cooler 200c2, third cooler 200c3, and fourth cooler 200c4) each has a body 210 that comes into contact with the power semiconductor package 110.

The body 210 may be configured with, for example, an inner plate 2101 that comes into contact with the power semiconductor package 110, an outer plate 2102 spaced apart from the inner plate 2101, and a plurality of partitions 2103 each one end portion of which is connected to the inner plate 2101 and the other end portion of which is connected to the outer plate 2102, as described above.

Through this, the manufacture of the cooler 200c (body 210) may be easily carried out.

The cooler 200c includes a header 220c provided with the passage 203 of cooling fluid thereinside and connected to the body 210.

The headers 220c are respectively provided on both sides (inlet side, outlet side) of each body 210 of the first cooler 200c1, the second cooler 200c2, the third cooler 200c3, and the fourth cooler 200c4.

The header 220c includes, for example, a first header 220c1, a second header 220c2, a third header 220c3, and a fourth header 220c4, which are respectively provided in the first cooler 200c1, the second cooler 200c2, the third cooler 200c3, and the fourth cooler 200c4.

Here, the header 220c provided on an inlet side of the body 210 may be referred to as an inlet-side header 220c, and the header 220c provided on an outlet side of the body 210 may be referred to as an outlet-side header 220c.

Specifically, for example, the inlet-side header 220c includes a first inlet-side header 220c1 provided in the first cooler 200c1, a second inlet-side header 220c2 provided in the second cooler 200c2, a third inlet-side header 220c3 provided in the third cooler 200c3, and a fourth inlet-side header 220c4 provided in the fourth cooler 200c4.

The outlet-side header 220c includes a first outlet-side header 220c1 provided in the first cooler 200c1, a second outlet-side header 220c2 provided in the second cooler 200c2, a third outlet-side header 220c3 provided in the third cooler 200c3, and a fourth outlet-side header 220c4 provided in the fourth cooler 200c4.

The body 210 and header 220c may be each formed of a metal member and integrally coupled to each other by brazing.

The header 220c includes, for example, an inner plate 2201 and an outer plate 2202 that are spaced apart from each other along a thickness direction of the power semiconductor package 110 to form the passage 203 of cooling fluid thereinside.

The first cooler 200c1 is provided with an inlet portion 22021 through which the cooling fluid flows in.

The first cooler 200c1 is provided with an outlet portion 22022 through which the cooling fluid flows out.

The inlet portion 22021 is disposed to pass through the inlet-side header 220c of the first cooler 200c1.

The inlet portion 22021 is disposed to pass through the outer plate 2202 of the inlet-side header 220c of the first cooler 200c1.

The outlet portion 22022 is disposed to pass through the outlet-side header 220c of the first cooler 200c1.

The outlet portion 22022 is disposed to pass through the outer plate 2202 of the outlet-side header 220c of the first cooler 200c1.

The headers 220c of each of the coolers 200c may be connected in communication with each other by a connecting member 300.

The connecting member 300 may be referred to as a "vertical connecting member" in that it is disposed along a vertical direction between the headers 220c.

The connecting member 300 is configured to be extensible.

Accordingly, when the power semiconductor package 110 is thermally deformed, the connecting member 300 may absorb the deformation.

Through this, the occurrence of damage caused by thermal deformation of the power semiconductor package 110 and cooler 200c may be respectively suppressed.

The connecting member 300 is configured with tubular portions 3001 disposed to have a tubular shape on both sides thereof and a corrugated portion 3002 disposed to be extensible between the tubular portions 3001.

The connecting members 300 may be respectively disposed between the header 220c1 of the first cooler 200c1 and the header 220c2 of the second cooler 200c2, between the header 220c2 of the second cooler 200c2 and the header 220c3 of the third cooler 200c3, and between the header 220c3 of the third cooler 200c3 and the header 220c4 of the fourth cooler 200c4.

The connecting member 300 includes, for example, a first vertical connecting member 300c1 provided between the first header 220c1 and the second header 220c2, a second vertical connecting member 300c2 provided between the second header 220c2 and the third header 220c3, and a third vertical connecting member 300c3 provided between the third header 220c3 and the fourth header 220c4.

Each of the headers 220c is provided with the connecting member coupling portion 230 to which the connecting member 300 is coupled to overlap along a thickness direction of the power semiconductor package 110.

The connecting member coupling portion 230 of the header 220c is configured to be coupled in an overlapping manner along a thickness direction of the power semiconductor package 110.

The connecting member coupling portion 230 of the header 220c includes a recessed portion 2301 that is recessed in a thickness direction to receive an end portion of the connecting member 300.

The recessed portion 2301 includes an inner width that is larger than a maximum outer width of the connecting member 300.

The recessed portion 2301 is configured with, for example, a recessed bottom portion 23011 that is recessed along a thickness direction of the power semiconductor package 110 and a side wall portion 230012 having an inner width greater than a maximum outer width of the connecting member 300.

The connecting member coupling portion 230 includes an overlapping section 2302 that protrudes from the recessed portion 2301 to overlap in a length direction with an end portion of the connecting member 300.

The overlapping section 2302 is configured to protrude from the recessed bottom portion 23011.

The overlapping section 2302 is configured to be inserted into the tubular portion 3001 of the connecting member 300.

The overlapping section 2302 includes, for example, an outer surface that comes into surface contact with an inner surface of the tubular portion 3001 of the connecting member 300.

As shown in FIG. 23, each of the connecting members 300 is coupled to each of the headers 220c in an extended state.

Each of the headers 220c and the connecting member 300 may be integrally coupled to each other by brazing.

Insertion spaces for the power semiconductor packages 110 (first power semiconductor package 111, second power semiconductor package 112, and third power semiconductor package 113) are formed between the first cooler 200c1, second cooler 200c2, third cooler 200c3, and fourth cooler 200c4, respectively.

A heat transfer material 205 may be inserted between mutual contact surfaces of the power semiconductor package 110 and each of the coolers 200c.

When the power semiconductor package 110 is inserted into each of the insertion spaces, each of the connecting members 300 is pressed and contracted in a top-bottom direction to allow the power semiconductor package 110 and each of the coolers 200c to come into contact with each other (see FIG. 22).

Meanwhile, as shown in FIG. 24, the inlet portion 22021 and outlet portion 22022 of the first cooler 200c1 may be connected to a cooling fluid circulation circuit 400.

The cooling fluid circulation circuit 400 is provided with a pump 402 that accelerates the movement of the cooling fluid and a heat exchanger 401 in which the cooling fluid is cooled through heat exchange.

With this configuration, when an operation is initiated, the power semiconductor packages 110 respectively generate heat energy through heat generation. The heat energy generated in the power semiconductor package 110 is transferred to the first cooler 200c1, the second cooler 200c2, the third cooler 200c3, and the fourth cooler 200c4, respectively.

When an operation is initiated, the pump 402 of the cooling fluid circulation circuit 400 is operated, and the cooling fluid of the cooling fluid circulation circuit 400 is cooled while passing through the heat exchanger 401.

The cooling fluid cooled by way of the heat exchanger 401 flows into the inlet portion 22021 of the first cooler 200c1.

Part of the cooling fluid flowing into the inlet portion 22021 moves along an inside of the first cooler 200c1. At this time, the heat energy generated from the first power semiconductor package 111 is absorbed to increase in temperature.

Another part of the cooling fluid flowing into the inlet portion 22021 moves to the second cooler 200c2, the third cooler 200c3, and the fourth cooler 200c4, respectively, by way of the inlet-side connecting member 300.

The cooling fluid moved to the second cooler 200c2, the third cooler 200c3, and the fourth cooler 200c4 absorbs heat energy generated from the power semiconductor package 110 to move to the outlet header 220c with an increased temperature.

In this embodiment, since the movement directions of the cooling fluids inside the first cooler 200c1, the second cooler 200c2, the third cooler 200c3, and the fourth cooler 200c4 are the same, a temperature deviation of the cooling fluid hardly occurs, and thus lower and upper surfaces of the first power semiconductor package 111, the second power semiconductor package 112, and the third power semiconductor package 113 may be cooled almost uniformly so as to suppress a temperature deviation between the lower and upper surfaces from occurring.

The cooling fluids moved to the respective outlet-side headers 220c are moved to the cooling fluid circulation circuit 400 through the outlet portion 22022.

The cooling fluid moved to the cooling fluid circulation circuit 400 continuously cools the power semiconductor package 110 while repeating a process of cooling through heat exchange in the heat exchanger 401, and absorbing the heat energy of the power semiconductor package 110 in the first cooler 200c1, the second cooler 200c2, the third cooler 200c3, and the fourth cooler 200c4.

In the above, specific embodiments of the present disclosure have been shown and described. However, the present disclosure may be implemented in various forms without departing from the concept or gist thereof, and thus the embodiments described above should not be limited to specific contents for carrying out the disclosure.

Furthermore, the foregoing embodiments should be broadly construed within the scope of the technical concept defined by the appended claims even though they are not specifically disclosed in the detailed description herein. Moreover, all changes and modifications within the technical scope of the claims and the equivalent scope thereof should be construed to be included in the appended claims.

## Claims

1. A double-side cooling power semiconductor package comprising:
a plate-shaped power semiconductor package;
a plurality of coolers provided with passages of cooling fluid thereinside, respectively, and disposed on both plate surfaces of the power semiconductor package, respectively, so as to allow heat exchange; and
a connecting member provided with the passage of cooling fluid thereinside, and connected in communication with the plurality of coolers,
wherein the connecting member is disposed to be extensible.

2. The double-side cooling power semiconductor package of claim 1, wherein the connecting member is provided with a corrugated pipe shape.

3. The double-side cooling power semiconductor package of claim 1, wherein the connecting member is disposed to be extensible along a thickness direction of the power semiconductor package.

4. The double-side cooling power semiconductor package of claim 1, wherein the connecting member is disposed to be extensible along a plate surface direction of the power semiconductor package.

5. The double-side cooling power semiconductor package of claim 1, wherein the plurality of coolers respectively comprise:
an inner plate that comes into contact with the power semiconductor;
an outer plate disposed to be spaced apart from the inner plate; and
a partition, one side of which is connected to the inner plate and the other side of which is connected to the outer plate.

6. The double-side cooling power semiconductor package of claim 1, wherein the plurality of coolers respectively comprise:
an inner plate that comes into contact with the power semiconductor package;
an outer plate disposed to be spaced apart from the inner plate; and
a heat dissipation fin, one side of which is connected to the inner plate and the other side of which is connected to the outer plate.

7. The double-side cooling power semiconductor package of claim 6, wherein the plurality of coolers respectively comprise:
an upper cooler provided on an upper side of the power semiconductor package; and
a lower cooler provided on a lower side of the power semiconductor package, and
wherein the connecting member is provided at the inlet-side and outlet-side end portions of the lower cooler and the upper cooler, respectively, with respect to a flow direction of the cooling fluid.

8. The double-side cooling power semiconductor package of claim 7, wherein the cooler further comprises headers provided at the inlet-side and outlet-side end portions of the lower cooler and upper cooler, respectively, and
wherein the connecting member is vertically disposed between a header of the upper cooler and a header of the lower cooler to be connected in communication with the header of the upper cooler and the header of the lower cooler.

9. The double-side cooling power semiconductor package of claim 8, wherein the header is provided with a connecting member coupling portion to which the connecting member is coupled to overlap along a thickness direction of the power semiconductor package.

10. The double-side cooling power semiconductor package of claim 9, wherein the connecting member coupling portion comprises a recessed portion that is recessed in a thickness direction so as to receive an end portion of the connecting member.

11. The double-side cooling power semiconductor package of claim 10, wherein the recessed portion is provided with an inner width greater than a maximum outer width of the connecting member.

12. The double-side cooling power semiconductor package of claim 11, wherein the connecting member coupling portion is provided with an overlapping section that protrudes from the recessed portion to overlap with an end portion of the connecting member in a length direction.

13. The double-side cooling power semiconductor package of claim 12, wherein the overlapping section has a length smaller than a depth of the recessed portion.

14. The double-side cooling power semiconductor package of claim 7, wherein the inner plate, outer plate and heat dissipation fin are formed of a metal member, and
wherein the inner plate, outer plate, and heat dissipation fin are coupled to one another by brazing.

15. The double-side cooling power semiconductor package of claim 7, wherein the power semiconductor package comprises a first power semiconductor package, a second power semiconductor package, and a third power semiconductor package spaced apart from one another along a plate surface direction,
wherein the upper cooler comprises a first upper cooler, a second upper cooler and a third upper cooler, which are respectively disposed on upper sides of the first power semiconductor package, the second power semiconductor package and the third power semiconductor package, and
wherein the lower cooler comprises a first lower cooler, a second lower cooler, and a third lower cooler, which are respectively disposed on lower sides of the first power semiconductor package, the second power semiconductor package, and the third power semiconductor package.

16. The double-side cooling power semiconductor package of claim 15, wherein the connecting member comprises:
an upper horizontal connecting member that connects the first upper cooler, the second upper cooler, and the third upper cooler along a horizontal direction; and
a lower horizontal connecting member that connects the first lower cooler, the second lower cooler, and the third lower cooler along a horizontal direction.

17. The double-side cooling power semiconductor package of claim 6, wherein the power semiconductor package comprises a first power semiconductor package, a second power semiconductor package, and a third power semiconductor package disposed to be spaced apart from one another along a thickness direction,
wherein the cooler comprises a first cooler disposed on a lower side of the first power semiconductor package, a second cooler disposed on an upper side of the first power semiconductor package, a third cooler disposed on an upper side of the second power semiconductor package, and a fourth cooler disposed on an upper side of the third power semiconductor package,
wherein the respective inlet-side end portions of the first cooler, second cooler, third cooler and fourth cooler are connected in communication with one another by the connecting member, and
wherein the respective outlet-side end portions of the first cooler, second cooler, third cooler and fourth cooler are connected in communication with one another by the connecting member.

18. The double-side cooling power semiconductor package of claim 17, wherein a first header, a second header, a third header and a fourth header are respectively provided at inlet-side and outlet-side end portions of the first cooler, the second cooler, the third cooler and the fourth cooler with respect to a movement direction of the cooling fluid, and
wherein the connecting member comprises a first vertical connecting member, a second vertical connecting member, and a third vertical connecting member disposed in a vertical direction between the first header, the second header, the third header, and the fourth header spaced apart vertically from one another.

19. The double-side cooling power semiconductor package of any one of claims 1 to 18, further comprising:
a thermally conductive material inserted between contact surfaces of the power semiconductor package and the cooler.
